# EUROPÄISCHE PATENTANMELDUNG

(11) **EP 3 382 744 A1**
(43) Veröffentlichungstag der Anmeldung: **03.10.2018**
(21) Anmeldenummer: 18166536.5
(22) Anmeldetag: 16.02.2016
(51) Int. Cl.: H01L 21/20, B23P 19/00, H01L 21/67, H01L 21/66, H01L 25/00, H01L 21/18

(54) **VORRICHTUNG ZUM BONDEN VON SUBSTRATEN**

(62) Teilanmeldung aus: 16705484.0
(71) Anmelder: EV Group E. Thallner GmbH, 4782 St. Florian am Inn (AT)
(72) Erfinder: Kurz, Florian, 4775 Taufenkirchen/Pram (AT); WAGENLEITNER, Thomas, 4971 Aurolzmünster (AT); Plach, Thomas, 4782 St. Florian am Inn (AT); SÜSS, Jürgen Markus, 4791 Rainbach b. Schärding (AT)
(74) Vertreter: Schneider, Sascha

(57) **Zusammenfassung**

Die vorliegende Erfindung betrifft eine Vorrichtung zum Bonden eines ersten Substrats (2) mit einem zweiten Substrat (2').

## Beschreibung

Die vorliegende Erfindung betrifft ein Verfahren bzw. eine Vorrichtung zum Bonden eines ersten Substrats mit einem zweiten Substrat gemäß den nebengeordneten Ansprüchen.

In der Halbleiterindustrie werden seit mehreren Jahren Substrate zueinander ausgerichtet und miteinander verbunden. Die Verbindung, das sogenannte Bonden, dient dabei dem Aufbau eines Multisubstratstapels. In einem derartigen Multisubstratstapel können funktionale Einheiten, insbesondere Speicher, Mikroprozessoren, MEMs etc. miteinander verbunden und damit miteinander kombiniert werden. Durch diese Kombinationsmöglichkeiten ergeben sich vielfältige Anwendungsmöglichkeiten.

Die Dichte der funktionalen Einheiten steigt von Jahr zu Jahr. Durch die voranschreitende Technologieentwicklung verringert sich die Größe der funktionalen Einheiten immer mehr. Die steigende Dichte geht daher mit einer größeren Stückzahl an funktionalen Einheiten pro Substrat einher. Diese Steigerung der Stückzahl ist maßgeblich für die Senkung der Stückkosten verantwortlich.

Der Nachteil mit immer kleiner werdenden funktionalen Einheiten besteht vor allem in der immer schwerer werdenden Realisierung einer fehlerfreien, insbesondere aber auch vollständigen, Überlagerung aller funktionalen Einheiten entlang des Bondinterfaces der beiden Substrate.

Das größte Problem in der heutigen Ausrichtungstechnologie besteht also nicht immer nur darin, zwei Substrate, insbesondere zwei Wafer, anhand von Ausrichtungsmarken zueinander auszurichten, sondern in der Erzeugung einer fehlerfreien, insbesondere vollständigen, daher sich über die gesamte Fläche des Substrats erstreckenden, Korrelation von Punkten des ersten Substrats, mit den Punkten eines zweiten Substrats. Die Erfahrung zeigt, dass die Strukturen auf den Oberflächen der Substrate nach einem Bondvorgang im Allgemeinen nicht kongruent zueinander sind. Eine allgemeine, insbesondere globale, Ausrichtung und ein darauf folgender Bondingschritt zweier Substrate sind daher nicht immer ausreichend um eine vollständige und fehlerfreie Kongruenz der gewünschten Punkte an jedem Punkt der Substratoberflächen zu erhalten.

Im Stand der Technik existieren zwei grundlegende Probleme, die einer einfachen, globalen Ausrichtung und einem darauffolgenden Bondingschritt im Wege stehen.

Erstens unterliegen die Positionen der Strukturen des ersten und/oder zweiten Substrats im Allgemeinen einer Abweichung von den theoretischen Positionen. Diese Abweichung kann mehrere Gründe haben.

Denkbar wäre beispielsweise, dass die realen, gefertigten Strukturen von ihren idealen Positionen abweichen, weil die Herstellprozesse fehlerhaft waren oder zumindest eine Toleranz aufweisen. Ein Beispiel dafür wäre die wiederholte Anwendung einer Lithographie durch einen Step-And-Repeat Prozess, der bei jeder translatorischen Verschiebung des Stempels, einen kleinen aber signifikanten Fehler in der Position mit sich bringt.

Ein weiterer, weniger trivialer Grund wäre die Verformung des Substrats durch mechanische, insbesondere aber thermische Belastung. Ein Substrat besitzt beispielsweise zum Zeitpunkt der Herstellung der Strukturen eine definierte Temperatur. Diese Temperatur bleibt im Allgemeinen nicht für den gesamten Prozessfluss des Substrats erhalten, sondern ändert sich. Mit der Temperaturänderung geht eine thermische Ausdehnung und damit, im idealsten Fall eine Änderung des Durchmessers, im ungünstigsten Fall eine komplexe thermische Verformung einher.

Zweitens können selbst zwei Substrate, die kurz vor der Kontaktierung und dem eigentlichen Bondvorgang, fehlerfreie, insbesondere vollflächige, Kongruenz, also eine Überlappung aller Strukturen besitzen, diese Kongruenz während des Bondvorgangs verlieren. Daher kommt dem Bondprozess an sich ein entscheidender Einfluss bei der Erzeugung eines fehlerfreien, daher eine perfekte Kongruenz der Strukturen aufweisenden, Substratstapels zu.

Drittens können Schichten und Strukturen, die auf die Substrate aufgebracht werden, Spannungen in einem Substrat erzeugen. Bei den Schichten kann es sich beispielsweise um Isolationsschichten, bei den Strukturen um throughsilicon-vias (TSVs), handeln.

Eines der größten technischen Probleme beim permanenten Verbinden zweier Substrate stellt die Ausrichtungsgenauigkeit der funktionalen Einheiten zwischen den einzelnen Substraten dar. Obwohl die Substrate durch Ausrichtungsanlagen sehr genau zueinander ausgerichtet werden können, kann es während des Bondvorgangs selbst zu Verzerrungen der Substrate kommen. Durch die so entstehenden Verzerrungen werden die funktionalen Einheiten nicht notwendigerweise an allen Positionen korrekt zueinander ausgerichtet sein. Die Ausrichtungsungenauigkeit an einem bestimmten Punkt am Substrat kann ein Resultat einer Verzerrung, eines Skalierungsfehlers, eines Linsenfehlers (Vergrößerungs- bzw. Verkleinerungsfehlers) etc. sein. In der Halbleiterindustrie werden alle Themenbereiche, die sich mit derartigen Problemen befassen unter dem Begriff "Overlay" subsumiert. Eine entsprechende Einführung zu diesem Thema findet man beispielsweise in: Mack, Chris. Fundamental Principles of Optical Lithography - The Science of Microfabrication. WILEY. 2007*, Reprint 2012.*

Jede funktionale Einheit wird vor dem eigentlichen Herstellprozess im Computer entworfen. Beispielsweise werden Leiterbahnen, Mikrochips, MEMS, oder jede andere mit Hilfe der Mikrosystemtechnik herstellbare Struktur, in einem CAD (engl.: computer aided design) Programm entworfen. Während der Herstellung der funktionalen Einheiten zeigt sich allerdings, dass es immer eine Abweichung zwischen den idealen, am Computer konstruierten, und den realen, im Reinraum produzierten, funktionalen Einheiten gibt. Die Unterschiede sind vorwiegend auf Limitierungen der Hardware, also ingenieurstechnische Probleme, sehr oft aber auf physikalische Grenzen, zurückzuführen. So ist die Auflösungsgenauigkeit einer Struktur, die durch einen photolithographischen Prozess hergestellt wird, durch die Größe der Aperturen der Photomaske und die Wellenlänge des verwendeten Lichts begrenzt. Maskenverzerrungen werden direkt in den Photoresist übertragen. Linearmotoren von Maschinen können nur innerhalb einer vorgegebenen Toleranz reproduzierbare Positionen anfahren, etc. Daher verwundert es nicht, dass die funktionalen Einheiten eines Substrats nicht exakt den am Computer konstruierten Strukturen gleichen können. Alle Substrate besitzen daher bereits vor dem Bondprozess eine nicht vernachlässigbare Abweichung vom Idealzustand.
Vergleicht man nun die Positionen und/oder Formen zweier gegenüberliegender funktionaler Einheiten zweier Substrate unter der Annahme, das keines der beiden Substrate durch einen Verbindungsvorgang verzerrt wird, so stellt man fest, dass im Allgemeinen bereits eine nicht perfekte Deckung der funktionalen Einheiten vorliegt, da diese durch die oben beschriebenen Fehler vom idealen Computermodell abweichen. Die häufigsten Fehler, werden in Figur 8 (*Nachgebildet von:* *http:*//*commons.wikimedia.org*/*wiki*/*File:Overlay*_- *typical_model_terms_DE.svg*, *24.05.2013 und* Mack, Chris. Fundamental Principles of Optical Lithography - The Science of Microfabrication. Chichester: WILEY, p. 312, 2007*, Reprint 2012*) dargestellt. Gemäß den Abbildungen kann man grob zwischen globalen und lokalen bzw. symmetrischen und asymmetrischen Overlayfehlern unterschieden. Ein globaler Overlayfehler ist homogen, daher unabhängig vom Ort. Er erzeugt die gleiche Abweichung zwischen zwei gegenüberliegenden funktionalen Einheiten unabhängig von der Position. Die klassischen globalen Overlayfehler sind die Fehler I. und II, welche durch eine Translation bzw. Rotation der beiden Substrate zueinander entstehen. Die Translation bzw. Rotation der beiden Substrate erzeugt einen dementsprechenden translatorischen bzw. rotatorischen Fehler für alle, jeweils gegenüberliegenden, funktionalen Einheiten auf den Substraten. Ein lokaler Overlayfehler entsteht ortsabhängig, vorwiegend durch Elastizitäts- und/oder Plastizitätsprobleme und/oder durch Vorprozesse, im vorliegenden Fall vor allem hervorgerufen durch die sich kontinuierlich ausbreitende Bondwelle. Von den dargestellten Overlay Fehlern werden vor allem die Fehler III. und IV. als "run-out" Fehler bezeichnet. Dieser Fehler entsteht vor allem durch eine Verzerrung mindestens eines Substrats während eines Bondvorgangs. Durch die Verzerrung mindestens eines Substrats werden auch die funktionalen Einheiten des ersten Substrats in Bezug auf die funktionalen Einheiten des zweiten Substrats verzerrt. Die Fehler I. und II. können allerdings ebenfalls durch einen Bondprozess entstehen, werden allerdings von den Fehlern III- und IV. meistens so stark überlagert, dass sie nur schwer erkennbar bzw. messbar sind. Dies gilt für Bonder, insbesondere Fusionsbonder, der neuesten Bauart, die eine extrem genaue Möglichkeit der x- und/oder y- und/oder Rotationskorrektur besitzen.

Im Stand der Technik existiert bereits eine Anlage, mit deren Hilfe man lokale Verzerrungen zumindest teilweise reduzieren kann. Es handelt sich dabei um eine lokale Entzerrung durch die Verwendung aktiver Steuerelemente (WO2012/083978A1).

Im Stand der Technik existieren erste Lösungsansätze zur Korrektur von "run-out"-Fehlern. Die US20120077329A1 beschreibt eine Methode, um eine gewünschte Ausrichtungsgenauigkeit zwischen den funktionalen Einheiten zweier Substrate während und nach dem Bonden zu erhalten, indem das untere Substrat nicht fixiert wird. Dadurch ist das untere Substrat keinen Randbedingungen unterworfen und kann während des Bondvorganges frei an das obere Substrat bonden. Ein wichtiges Merkmal im Stand der Technik stellt vor allem die flache Fixierung eines Substrats, meistens mittels einer Vakuumvorrichtung, dar.

Die entstehenden "run-out" Fehler werden in den meisten Fällen radialsymmetrisch um die Kontaktstelle stärker, nehmen daher von der Kontaktstelle zum Umfang zu. In den meisten Fällen handelt es sich um eine linear zunehmende Verstärkung der "run-out" Fehler. Unter speziellen Bedingungen können die "run-out" Fehler auch nichtlinear zunehmen.

Unter besonders optimalen Bedingungen können die "run-out" Fehler nicht nur durch entsprechende Messgeräte (EP2463892) ermittelt, sondern auch durch mathematische Funktionen beschrieben, werden. Da die "run-out" Fehler Translationen und/oder Rotationen und/oder Skalierungen zwischen wohldefinierten Punkten darstellen, werden sie mit Vorzug durch Vektorfunktionen beschrieben. Im Allgemeinen handelt es sich bei dieser Vektorfunktion um eine Funktion f:R²→R², daher um eine Abbildungsvorschrift, die den zweidimensionalen Definitionsbereich der Ortskoordinaten auf den zweidimensionalen Wertebereich von "run-out" Vektoren abbildet. Obwohl noch keine exakte mathematische Analyse der entsprechenden Vektorfelder vorgenommen werden konnte, werden Annahmen bezüglich der Funktionseigenschaften getätigt. Die Vektorfunktionen sind mit großer Wahrscheinlichkeit mindestens Cⁿ n>=1, Funktionen, daher mindestens einmal stetig differenzierbar. Da die "run-out" Fehler vom Kontaktierungspunkt zum Rand hinzunehmen, wird die Divergenz der Vektorfunktion wahrscheinlich von Null verschieden sein. Bei dem Vektorfeld handelt es sich daher mit großer Wahrscheinlichkeit um ein Quellenfeld.

Man ermittelt die "run-out" Fehler am besten in Bezug zu Strukturen. Unter einer Struktur versteht man jedes beliebige Element eines ersten bzw. zweiten Substrats, welches mit einer Struktur auf dem zweiten bzw. ersten Substrat korreliert werden soll. Bei einer Struktur handelt es sich daher beispielsweise um
- Ausrichtungsmarken
- Ecken bzw. Kanten, insbesondere Ecken und Kanten funktionaler Einheiten
- Kontaktpads, insbesondere Through Silicon Vias (TSVs) oder Through polymer Vias (TPVs)
- Leiterbahnen
- Vertiefungen, insbesondere Löcher oder Senken.

Der "run-out"-Fehler ist im Allgemeinen positionsabhängig und ist im mathematischen Sinne ein Verschiebungsvektor, zwischen einem realen und einem idealen Punkt. Da der "run-out"-Fehler im Allgemeinen positionsabhängig ist, wird er idealerweise durch Vektorfelder angegeben. Im weiteren Verlauf des Textes wird der "run-out"-Fehler, wenn nicht anders erwähnt, nur mehr punktuell betrachtet um die Beschreibung zu erleichtern.

Der "run-out"-Fehler R setzt sich aus zwei Teilkomponenten zusammen.

Die erste Teilkomponente R1 beschreibt den intrinsischen Teil des "run-out"-Fehlers, also jenen Teil, der auf eine fehlerhafte Herstellung der Strukturen oder eine Verzerrung des Substrats zurückzuführen ist. Er wohnt also dem Substrat inne. Es ist dabei zu beachten, dass ein Substrat auch einen intrinsischen "run-out" Fehler besitzen kann, wenn die Strukturen zwar bei einer ersten Temperatur korrekt hergestellt wurden, das Substrat aber bis zum Bondprozess einer Temperaturänderung auf eine zweite Temperatur unterliegt und es dadurch zu thermischen Dehnungen kommt, die das gesamte Substrat und damit auch die darauf befindlichen Strukturen verzerren. Es genügen bereits Temperaturdifferenzen von einigen wenigen Kelvin, manchmal sogar zehntel Kelvin, um derartige Verzerrungen zu erzeugen.

Die zweite Teilkomponente R2 beschreibt den extrinsischen Teil des "run-out"-Fehlers, daher jenen Teil, der erst durch den Bondprozess verursacht wird. Er ist vor dem Bondprozess nicht vorhanden. Darunter fallen vor allem lokale und/oder globale Verzerrungen des ersten und/oder zweiten Substrats durch zwischen den Substraten wirkende Kräfte, die zu einer Verformung im Nanometerbereich führen können.

Aufgabe der vorliegenden Erfindung ist es, eine Vorrichtung bzw. ein Verfahren zum Bonden zweier Substrate vorzusehen, mit dem die Bondgenauigkeit möglichst an jeder Position der Substrate erhöht wird. Es ist weiter Aufgabe der Erfindung, eine Vorrichtung bzw. ein Verfahren aufzuzeigen, mit dem eine fehlerfreie, insbesondere vollflächige, Kongruenz der Strukturen zweier Substrate erzeugt werden kann.

Die vorliegende Aufgabe wird mit den Merkmalen der nebengeordneten Ansprüche gelöst. Vorteilhafte Weiterbildungen der Erfindung sind in den Unteransprüchen angegeben. In den Rahmen der Erfindung fallen auch sämtliche Kombinationen aus zumindest zwei in der Beschreibung, in den Ansprüchen und/oder den Zeichnungen angegebenen Merkmalen. Bei angegebenen Wertebereichen sollen auch innerhalb der genannten Grenzen liegende Werte als Grenzwerte offenbart gelten und in beliebiger Kombination beanspruchbar sein. Soweit einzelne oder mehrere Verfahrensschritte auf unterschiedlichen Geräten oder Modulen ausführbar sind, werden diese als eigenständiges Verfahren jeweils separat offenbart.

Der Erfindung liegt der Gedanke zugrunde, eine Heiztemperatur T_{H} bereits während des Bondens zu reduzieren oder eine Heizung während des Bondens abzuschalten. Die Heiztemperatur T_{H} dient insbesondere zur Erzeugung einer zum Bonden ausreichenden Temperatur an einer Bondfläche der Substrate. Ein wichtiger Aspekt einer weiteren erfindungsgemäßen Ausführungsform besteht in der Aufhebung der Fixierung eines Substrats, insbesondere während des Bondens, um die freie Verformbarkeit des bondenden Substratstapels zu erlauben. Ein weiterer wichtiger Aspekt einer dritten erfindungsgemäßen Ausführungsform besteht in der Möglichkeit der Belüftung bzw. Druckbeaufschlagung des Substratstapels, insbesondere seiner Grenzfläche, während des Bondens.

Als erstes und/oder zweites Substrat kommen insbesondere Wafer in Frage.

Ein erfindungsgemäß charakteristischer Vorgang beim Bonden, insbesondere Permanentbonden, vorzugsweise Fusionsbonden, ist die möglichst zentrische, punktförmige Kontaktierung der beiden Substrate. Insbesondere kann die Kontaktierung der beiden Substrate auch nicht zentrisch erfolgen. Die sich von einem nicht-zentrischen Kontaktpunkt ausbreitende Bondwelle würde unterschiedliche Stellen des Substratrandes zu unterschiedlichen Zeiten erreichen. Entsprechend kompliziert wäre die vollständige mathematischphysikalische Beschreibung des Bondwellenverhaltens und der daraus resultierenden "run-out" Fehler Kompensation. Insbesondere wird der Kontaktierungspunkt nicht weit vom Zentrum des Substrats entfernt verortet, sodass die sich daraus möglicherweise ergebenden Effekte, zumindest am Rand vernachlässigbar sind. Die Distanz zwischen einem möglichen nicht-zentrischen Kontaktierungspunkt und dem Zentrum des Substrats ist vorzugsweise kleiner als 100mm, mit Vorzug kleiner als 10mm, mit größerem Vorzug kleiner als 1mm, mit größtem Vorzug kleiner als 0.1mm, mit allergrößtem Vorzug kleiner als 0.01mm. Im weiteren Verlauf der Beschreibung soll unter Kontaktierung im Regelfall eine zentrische Kontaktierung gemeint sein. Unter Zentrum versteht man im weiteren Sinne mit Vorzug den geometrischen Mittelpunkt eines zugrundeliegenden, wenn nötig um Asymmetrien kompensierten, idealen Körpers. Bei industrieüblichen Wafern mit einem Notch ist das Zentrum also der Kreismittelpunkt des Kreises, der den idealen Wafer ohne notch, umgibt. Bei industrieüblichen Wafern mit einem Flat (abgeflachte Seite) ist das Zentrum der Kreismittelpunkt des Kreises, der den idealen Wafer ohne flat, umgibt. Analoge Überlegungen gelten für beliebig geformte Substrate. In speziellen Ausführungsformen kann es allerdings von Nutzen sein, unter dem Zentrum den Schwerpunkt des Substrats zu verstehen. Um eine exakte, zentrische, punktförmige Kontaktierung zu gewährleisten, wird eine mit einer zentrischen Bohrung und einem darin translatorisch bewegbaren Stift versehene obere Aufnahmeeinrichtung (Probenhalter) mit einer radialsymmetrischen Fixierung versehen. Denkbar wäre auch die Verwendung einer Düse, welche ein Fluid, mit Vorzug ein Gas an Stelle des Stifts zur Druckbeaufschlagung verwendet. Des Weiteren kann sogar vollständig auf die Verwendung derartiger Elemente verzichtet werden, wenn man Vorrichtungen vorsieht, welche die beiden Substrate durch eine Translationsbewegung aneinander annähern können unter der weiteren Voraussetzung, dass mindestens eines der beiden Substrate, mit Vorzug das obere Substrat, auf Grund der Gravitation eine aufgeprägte Krümmung in Richtung des anderen Substrats besitzt, und daher bei der erwähnten translatorischen Annäherung, bei genügend geringem Abstand zum entsprechenden zweiten Substrat, automatisch kontaktiert.

Bei der radialsymmetrischen Fixierung/Halterung handelt es sich entweder um angebrachte Vakuumlöcher, eine kreisrunde Vakuumlippe oder vergleichbare Vakuumelemente, mit deren Hilfe das obere Substrat fixiert werden kann. Denkbar ist auch die Verwendung einer elektrostatischen Aufnahmeeinrichtung. Der Stift in der zentrischen Bohrung des oberen Probenhalters dient der steuerbaren Durchbiegung des fixierten, oberen Substrats.

In einer weiteren erfindungsgemäßen Ausführungsform kann die Aufnahmeeinrichtung so konstruiert sein, dass das erste und/oder zweite Substrat durch einen erzeugten Über- und/oder Unterdruck im Probenhalter konvex und/oder konkav gekrümmt wird. Dazu werden in der Aufnahmeeinrichtung vorzugsweise Vakuumbahnen und/oder mit Fluiden durchströmbare bzw. evakuierbare Hohlräume vorgesehen. Auf die Verwendung einer Düse zur punktgenauen Druckbeaufschlagung kann zugunsten eines sich global aufbauenden Drucks insbesondere verzichtet werden. Erfindungsgemäß denkbar sind Ausführungsformen, bei denen das Substrat abgedichtet und/oder anderweitig, insbesondere am Rand, fixiert wird. Wird beispielsweise eine Aufnahmeeinrichtung konstruiert, die einen Unterdruck in Bezug zur äußeren Atmosphäre erzeugt, so reicht eine Dichtung am Substratrand. Wird im Inneren der Aufnahmeeinrichtung ein Überdruck erzeugt, um das Substrat nach außen, also konvex, zu krümmen, wird das Substrat vorzugsweise randseitig, insbesondere mechanisch, fixiert. Durch die Beaufschlagung des Substrats von der Unterseite mittels Unter- bzw. Überdruck kann die Krümmung des Substrats exakt eingestellt werden.

Nach der erfolgten Kontaktierung der Zentren beider Substrate wird die Fixierung des oberen Probenhalters, insbesondere kontrolliert und schrittweise, gelöst. Das obere Substrat fällt einerseits durch die Schwerkraft und andererseits bedingt durch eine entlang der Bondwelle und zwischen den Substraten wirkende Bondkraft nach unten. Das obere Substrat wird radial vom Zentrum zum Seitenrand hin mit dem unteren Substrat verbunden. Es kommt so zu einer erfindungsgemäßen Ausbildung einer radialsymmetrischen Bondwelle, die insbesondere vom Zentrum zum Seitenrand verläuft. Während des Bondvorganges drücken die beiden Substrate das zwischen den Substraten vorliegende Gas, insbesondere Luft, vor der Bondwelle her und sorgen damit für eine Bondgrenzfläche ohne Gaseinschlüsse. Das obere Substrat liegt während des Fallens praktisch auf einer Art Gaspolster.

Das erste/obere Substrat unterliegt nach der Initiierung des Bonds an einer Bondinitiierungsstelle keiner zusätzlichen Fixierung, kann sich also abgesehen von der Fixierung an der Bondinitiierungsstelle frei bewegen und auch verzerren. Durch die erfindungsgemäß voranschreitende Bondwelle, die an der Bondwellenfront auftretenden Spannungszustände und die vorliegenden geometrischen Randbedingungen wird jedes, bezüglich seiner radialen Dicke infinitesimal kleine, Kreissegment einer Verzerrung unterliegen. Da die Substrate allerdings starre Körper darstellen, summieren sich die Verzerrungen als Funktion des Abstandes vom Zentrum her auf. Dies führt zu "run-out" Fehlern, die durch das erfindungsgemäße Verfahren und die erfindungsgemäße Vorrichtung beseitigt werden sollen.

Die Erfindung betrifft somit auch ein Verfahren und eine Vorrichtung, um den "run-out"-Fehler zwischen zwei gebondeten Substraten, insbesondere durch thermodynamische und/oder mechanische Kompensationsmechanismen, beim Bonden zu verringern oder sogar ganz zu vermeiden. Des Weiteren behandelt die Erfindung einen entsprechenden Artikel, der mit der erfindungsgemäßen Vorrichtung und dem erfindungsgemäßen Verfahren hergestellt wird.

Der "run-out"-Fehler ist insbesondere abhängig von der Position am Substrat entlang der Substratoberfläche. Es zeigt sich insbesondere, dass der "run-out"-Fehler vom Zentrum zur Peripherie des Substrats zunimmt. Derartige radialsymmetrische run-outs kommen vor allem bei fusionsgebondeten Substraten vor, die durch einen Stift (engl.: pin) zentrisch kontaktiert werden und deren Bondwelle sich nach der Kontaktierung selbstständig, insbesondere radial, ausbreitet.

Der "run-out" Fehler ist insbesondere abhängig von der Geschwindigkeit der Bondwelle. Im Allgemeinen wird der "run-out" Fehler größer, je höher die Bondwellengeschwindigkeit ist. Erfindungsgemäß werden daher bevorzugt Bondwellengeschwindigkeiten eingestellt, die kleiner sind als 100 mm/s, vorzugsweise kleiner als 50 mm/s, noch bevorzugter kleiner als 10 mm/s, am bevorzugtesten kleiner als 1 mm/s, am allerbevorzugtesten kleiner als 0.1 mm/s. In einer besonderen erfindungsgemäßen Ausführungsform wird die Bondwellengeschwindigkeit mit Messmitteln erfasst.

Der "run-out" Fehler ist insbesondere abhängig von dem Abstand (engl.: gap) zwischen den beiden Substraten unmittelbar vor dem Beginn des (Pre-)Bondprozesses. Soweit, insbesondere das obere, erste Substrat, durch Verformungsmittel mit einer ersten Kraft F₁ verformt wird, ist der Abstand zwischen den Substraten eine Funktion des Ortes. Insbesondere ist der Abstand zwischen den Substraten am Rand am größten. Der minimale Abstand ist im Bereich des konvexen Maximums des verformten Substrats verortet. Damit hat auch die Form eines verformten Substrats Einfluss auf den "run-out"-Fehler. Der Abstand zwischen den Substraten am Rand (Substratrandabstand D) wird unmittelbar vor dem Bonden insbesondere kleiner als 5 mm, vorzugsweise kleiner als 2 mm, noch bevorzugter kleiner als 1 mm, am bevorzugtesten kleiner als 0.5 mm, am allerbevorzugtesten kleiner als 0.1 mm eingestellt. Der Abstand zwischen den Substraten unterhalb des konvexen Maximums wird unmittelbar vor dem Bonden insbesondere kleiner als 1 mm, vorzugsweise kleiner als 100 µm, noch bevorzugter kleiner als 10 µm, am bevorzugtesten kleiner als 1 µm, am allerbevorzugtesten kleiner als 100 nm, eingestellt.
Der "run-out" Fehler ist insbesondere abhängig von der Art und Form des Probenhalters sowie der daraus resultierenden Fixierung/Halterung des jeweiligen Substrats. Die Druckschrift WO2014/191033A1 offenbart mehrere Ausführungsformen bevorzugter Probenhalter, auf die insofern Bezug genommen wird. Bei den offenbarten Prozessen ist eine Loslösung des Substrats von einem Probenhalter nach der Aufhebung der Fixierung, insbesondere Vakuumfixierung, von entscheidender Bedeutung. Die Oberflächenrauheit des Probenhalters wird möglichst groß, seine Welligkeit möglichst gering gewählt. Eine große Oberflächenrauheit sorgt für möglichst wenig Kontaktstellen zwischen der Probenhalteroberfläche und dem Substrat. Die Trennung des Substrats vom Probenhalter erfolgt daher mit minimalem Energieaufwand. Die Welligkeit ist vorzugsweise minimal, um nicht durch die Probenhalteroberfläche neue Quellen für einen "run-out" zu schaffen. Es wird darauf hingewiesen, dass die Aussagen über die Welligkeit nicht bedeuten, dass die Oberfläche des Probenhalters nicht auch als Ganzes gekrümmt sein darf.

Die Rauheit wird entweder als mittlere Rauheit, quadratische Rauheit oder als gemittelte Rauhtiefe angegeben. Die ermittelten Werte für die mittlere Rauheit, die quadratische Rauheit und die gemittelte Rauhtiefe unterscheiden sich im Allgemeinen für dieselbe Messstrecke bzw. Messfläche, liegen aber im gleichen Größenordnungsbereich. Daher sind die folgenden Zahlenwertebereiche für die Rauheit entweder als Werte für die mittlere Rauheit, die quadratische Rauheit oder für die gemittelte Rauhtiefe zu verstehen. Die Rauheit wird insbesondere größer als 10 nm, vorzugsweise größer als 100 nm, noch bevorzugter größer als 1 µm, am bevorzugtesten größer als 10 µm, am allerbevorzugtesten größer als 100 µm, eingestellt.

Der "run-out" Fehler ist insbesondere abhängig von zeitlichen Aspekten. Eine sich zu schnell ausbreitende Bondwelle gibt dem Material der Substrate kurz nach und/oder auf und/oder vor der Bondwelle nicht genug Zeit, um sich optimal miteinander zu verbinden. Es kann daher auch von entscheidender Bedeutung sein, die Bondwelle zeitabhängig zu steuern.

Der "run-out" Fehler ist insbesondere abhängig vom Ladevorgang des Substrats auf den Probenhalter. Bei der Aufbringung und Fixierung des Substrats kann es zu einer Verzerrung des Substrats kommen, welche durch die Fixierung aufrechterhalten und während des (Pre-)Bonds mit in den Substratstapel eingebracht wird. Das Substrat wird daher möglichst ohne Verzerrung von einem Endeffektor auf den Probenhalter übergeben.

Der "run-out" Fehler ist insbesondere abhängig von Temperaturunterschieden und/oder Temperaturschwankungen zwischen den beiden Substraten. Die Substrate werden insbesondere aus unterschiedlichen Prozessschritten oder unterschiedlichen Prozessmodulen dem Bondmodul zugeführt. In diesen Prozessmodulen konnten unterschiedliche Prozesse bei unterschiedlichen Temperaturen durchgeführt worden sein. Des Weiteren können der obere und unter Probenhalter einen unterschiedlichen Aufbau, eine unterschiedliche Konstruktionsweise und damit unterschiedliche physikalische, insbesondere thermische, Eigenschaften aufweisen. Denkbar ist beispielsweise, dass sich die thermischen Massen und/oder die thermischen Leitfähigkeiten der Probenhalter voneinander unterscheiden. Dies führt zu einer unterschiedlichen Ladetemperatur oder zu einer unterschiedlichen Temperatur im Zeitpunkt des (Pre-)Bonds. Die Probenhalter zur Durchführung der erfindungsgemäßen Prozesse werden daher vorzugsweise mit Heiz- und/oder Kühlsystemen ausgestattet, um die Temperatur wenigstens eines (vorzugsweise beider) Substrats exakt einstellen zu können. Insbesondere ist es denkbar, die Temperaturen der beiden Substrate auf unterschiedliche Werte anzupassen, damit durch eine thermische Beaufschlagung von zumindest einem der beiden Substrate das Substrat thermisch global verzerrt wird. Dadurch erreicht man die Anpassung eines Substrats auf einen gewünschten Ausgangszustand, insbesondere um die "run-out" Fehlerkomponente R1 zu kompensieren.

Der "run-out"-Fehler ist insbesondere abhängig vom Umgebungsdruck. Die Auswirkungen des Umgebungsdrucks wurden ausführlich in der WO2014/191033A1 erörtert und offenbart. Hierauf wird insofern Bezug genommen.

Der "run-out" Fehler ist insbesondere abhängig von einer Symmetrie des Systems, so dass vorzugsweise möglichst viele (noch bevorzugter zumindest der überwiegende Teil) Komponenten symmetrisch aufgebaut und/oder angeordnet werden. Insbesondere sind die Dicken der Substrate unterschiedlich. Des Weiteren können auf jedem Substrat unterschiedliche Schichtreihenfolgen unterschiedlicher Materialien mit unterschiedlichen mechanischen Eigenschaften vorhanden und zu berücksichtigen sein. Des Weiteren wird eines der Substrate vorzugsweise verformt, während das andere Substrat flach auf einem Probenhalter aufliegt. Alle Eigenschaften, Parameter und Ausführungsformen, die dazu führen, dass eine Asymmetrie vorliegt, wirken sich insbesondere auf den "run-out"-Fehler aus. Einige dieser Asymmetrien können nicht vermieden werden. So sind die Dicken von Substraten, die Schichten auf den Substraten sowie die funktionalen Einheiten durch den Prozess und Kundenvorgaben definiert. Erfindungsgemäß wird insbesondere durch Variation anderer, veränderbarer Parameter versucht, den "run-out" weitestgehend zu minimieren, insbesondere vollständig zu eliminieren.

Der "run-out" Fehler ist insbesondere positionsabhängig. Ziel der erfindungsgemäßen Maßnahmen ist es insbesondere, an jeder Position einen "run-out"-Fehler zu erhalten, der kleiner ist als 10 µm, vorzugsweise kleiner ist als 1 µm, noch bevorzugter kleiner ist als 100 nm, am bevorzugtesten kleiner ist als 10 nm, am allerbevorzugtesten kleiner ist als 1 nm.

### Probenhalter

Die Probenhalter, die für die erfindungsgemäßen Ausführungsformen vorzugsweise verwendet werden, verfügen über Fixierungen. Die Fixierungen dienen zum Festhalten der Substrate mit einer Fixierkraft oder mit einem entsprechenden Fixierdruck. Bei den Fixierungen kann es sich insbesondere um folgende handeln:
- Mechanische Fixierungen, insbesondere, Klemmen, oder
- Vakuumfixierungen, insbesondere mit
   ∘ einzeln ansteuerbare Vakuumbahnen oder
   ∘ miteinander verbundenen Vakuumbahnen, oder
- Elektrische Fixierungen, insbesondere elektrostatische Fixierungen, oder
- Magnetische Fixierungen oder
- Adhäsive Fixierungen, insbesondere
   ∘ Gel-Pak Fixierungen oder
   ∘ Fixierungen mit adhäsiven, insbesondere ansteuerbaren, Oberflächen.

Die Fixierungen sind insbesondere elektronisch ansteuerbar. Die Vakuumfixierung ist die bevorzugte Fixierungsart. Die Vakuumfixierung besteht vorzugsweise aus mehreren Vakuumbahnen, die an der Oberfläche des Probenhalters austreten. Die Vakuumbahnen sind vorzugsweise einzeln ansteuerbar. In einer technisch bevorzugten Anwendung sind einige Vakuumbahnen zu Vakuumbahnsegmenten vereint, die einzeln ansteuerbar sind, also separat evakuiert oder geflutet werden können. Jedes Vakuumsegment ist vorzugsweise unabhängig von den anderen Vakuumsegmenten. Damit erhält man die Möglichkeit des Aufbaus einzeln ansteuerbarer Vakuumsegmente. Die Vakuumsegmente sind vorzugsweise ringförmig konstruiert. Dadurch wird eine gezielte, radialsymmetrische, insbesondere von innen nach außen durchgeführte Fixierung und/oder Loslösung eines Substrats vom Probenhalter ermöglicht oder umgekehrt.

Mögliche Probenhalter wurden in den Druckschriften WO2014/191033A1, WO2013/023708A1, WO2012/079597A1 und WO2012/083978A1 offenbart. Auf diese wird insofern Bezug genommen.

### Überwachung der Bondwelle

Während mindestens eines, vorzugsweise aller, erfindungsgemäßen Prozessschritte ist es vorteilhaft, das Fortschreiten der Bondwelle oder zumindest den Zustand der Bondwelle zu erfassen und somit zu bestimmten Zeitpunkten zu ermitteln. Hierzu sind vorzugsweise Messmittel vorgesehen, insbesondere mit Kameras. Die Überwachung erfolgt vorzugsweise mittels:
- Kameras, insbesondere visuellen Kameras oder Infrarot-Kameras, und/oder
- Leitfähigkeitsmessgeräten.

Erfolgt die Ermittlung der Position der Bondwelle mit Hilfe einer Kamera, kann zu jedem Zeitpunkt die Position der Bondwelle, insbesondere der Bondwellenverlauf detektiert werden. Bei der Kamera handelt es sich vorzugsweise um eine Infrarotkamera, welche die Daten digitalisiert und an einen Computer weiterleitet. Der Computer ermöglicht danach die Auswertung der digitalen Daten, insbesondere die Ermittlung der Position der Bondwelle, die Größe der gebondeten Fläche oder weiterer Parameter.

Eine weitere Möglichkeit der Überwachung des Bondwellenfortschritts besteht in einer Messung der Oberflächenleitfähigkeit, die sich mit fortschreitender Bondwelle verändert. Dazu müssen die Voraussetzungen für eine derartige Messung gegeben sein. Die Messung der Oberflächenleitfähigkeit erfolgt insbesondere durch eine Kontaktierung zweier Elektroden an zwei gegenüberliegenden Positionen eines Substrats. In einer besonderen erfindungsgemäßen Ausführungsform kontaktieren die Elektroden den Rand der Substrate, wobei sie die Verbondung der Substrate am Rand nicht behindern. In einer zweiten, weniger bevorzugten erfindungsgemäßen Ausführungsform werden die Elektroden von der Oberfläche zurückgezogen, bevor die Bondwelle den Seitenrand der Substrate erreicht.

Nachfolgend werden Prozesse beschrieben, wobei die Prozesse vorzugsweise in der beschriebenen Reihenfolge, insbesondere als separate Schritte, ablaufen. Soweit nichts Anderes beschrieben ist, sind die Prozessschritte und Offenbarungen jeweils von einer Ausführungsform auf die andere übertragbar, falls dies für den Fachmann technisch ausführbar ist.

### Prozess gemäß erster Ausführungsform der Erfindung

In einem ersten Prozessschritt einer ersten Ausführungsform des erfindungsgemäßen Verfahrens werden zwei Substrate, eines auf einem ersten/oberen, das zweite auf einem zweiten/unteren Probenhalter positioniert und fixiert. Die Zuführung der Substrate kann dabei manuell, vorzugsweise aber durch einen Roboter, also automatisch, erfolgen. Der obere Probenhalter verfügt vorzugsweise über Verformungsmittel zur gezielten, insbesondere steuerbaren, Verformung des oberen, ersten Substrats mit einer ersten Kraft F₁. Der obere Probenhalter verfügt insbesondere über mindestens eine Öffnung, durch die ein Verformungsmittel, insbesondere ein Stift (engl.: pin), eine mechanische Verformung des oberen, ersten Substrats bewirken kann. Ein derartiger Probenhalter wird beispielsweise in der Druckschrift WO2013/023708A1 offenbart.

In einem zweiten Prozessschritt kontaktiert das Verformungsmittel, insbesondere ein Stift, die Rückseite des oberen, ersten Substrats und erzeugt eine leichte Verformung, insbesondere eine, von der Seite des Verformungsmittels (also von oben) als konkav bezeichnete, Durchbiegung. Das Verformungsmittel beaufschlagt das erste Substrat insbesondere mit einer ersten Kraft F₁ von mehr als 1 mN, vorzugsweise mehr als 10 mN, noch bevorzugter mehr als 50 mN, am bevorzugtesten mehr als 100 mN, jedoch insbesondere weniger als 5000 mN. Die Kraft ist zu gering, um das obere, erste Substrat vom Probenhalter zu lösen, aber stark genug, um die erfindungsgemäße Durchbiegung zu erzeugen. Die Kraft wirkt vorzugsweise möglichst punktförmig auf das Substrat ein. Da eine punktförmige Einwirkung tatsächlich nicht existiert, wirkt die Kraft vorzugsweise auf eine sehr geringe Fläche ein. Die Fläche ist insbesondere kleiner als 1cm², vorzugsweise kleiner als 0.1cm² noch bevorzugter kleiner als 0.01cm², am allerbevorzugtesten kleiner als 0.001 cm². Im Falle der Einwirkung auf eine Fläche von 0.001 cm² ist der einwirkende Druck erfindungsgemäß insbesondere größer als 1 MPa, vorzugsweise größer als 10 MPa, noch bevorzugter mehr als 50 MPa, am bevorzugtesten größer als 100 MPa, am allerbevorzugtesten größer als 1000 MPa. Die offenbarten Druckbereiche gelten auch für die weiteren, oben offenbarten Flächen.

In einem dritten Prozessschritt erfolgt insbesondere eine Relativannäherung der beiden Substrate, insbesondere durch die Relativannäherung der Probenhalter. Vorzugsweise wird der untere Probenhalter angehoben, sodass das untere, zweite Substrat sich dem oberen, ersten Substrat aktiv nähert. Denkbar ist aber auch die aktive Annäherung des oberen Probenhalters an den unteren Probenhalter oder die gleichzeitige Annäherung beider Probenhalter zueinander. Die Annäherung der beiden Substrate erfolgt insbesondere bis zu einem Abstand zwischen 1 µm und 2000 µm, vorzugsweise zwischen 10 µm und 1000 µm, noch bevorzugter zwischen 20 µm und 500 µm, am bevorzugtesten zwischen 40 µm und 200µm. Der Abstand ist definiert als die kleinste vertikale Distanz zwischen zwei Oberflächenpunkten der Substrate.

Vor dem Bonden oder Prebonden beziehungsweise Kontaktieren werden das erste und/oder das zweite Substrat durch Heizmittel aufgeheizt und/oder durch Kühlmittel gekühlt, also temperiert.

In einem vierten Prozessschritt erfolgt eine weitere Kraftbeaufschlagung des oberen, ersten Substrats. In einer ersten erfindungsgemäßen Vorgehensweise wird das erste Substrat mit einer zweite Kraft F₂ des Verformungsmittels von insbesondere mehr als 100 mN, vorzugsweise mehr als 500 mN, noch bevorzugter mehr als 1500 mN, am bevorzugtesten mehr als 2000 mN, am allerbevorzugtesten mehr als 3000 mN beaufschlagt. Hierdurch wird die erste Kontaktierung des oberen, ersten Substrats mit dem unteren, zweiten Substrat verursacht oder zumindest unterstützt. Die Berechnung der bevorzugt auftretenden Drücke erfolgt erneut durch Division der Kraft durch eine minimal angenommene Fläche von 0.001 cm².
In einem fünften Prozessschritt erfolgt insbesondere eine Deaktivierung der Heizmittel, insbesondere einer, insbesondere integral im unteren Probenhalter angeordneten, Heizung des unteren Probenhalters.

In einem sechsten Prozessschritt erfolgt insbesondere eine Überwachung der Ausbreitung der fortschreitenden Bondwelle (siehe auch oben "Überwachung der Bondwelle"). Die Überwachung verfolgt den Fortschritt der Bondwelle und damit den Fortschritt des Bondvorgangs insbesondere über einen Zeitraum von mehr als 1 s, vorzugsweise mehr als 2s, noch bevorzugter mehr als 3s, am bevorzugtesten mehr als 4s, am allerbevorzugtesten mehr als 5s. Anstatt der Verfolgung/Steuerung des Bondvorgangs über ein Zeitintervall, kann die Verfolgung der Bondwelle auch über die, insbesondere radiale, Position der Bondwelle angegeben werden. Die Verfolgung des Bondvorgangs erfolgt insbesondere solange, bis sich die Bondwelle an einer radialen Position befindet die mindestens 0.1 mal, vorzugsweise mindestens 0.2 mal, noch bevorzugter mindestens 0.3 mal, am bevorzugtesten mindestens 0.4 mal, am allerbevorzugtesten 0.5 mal dem Durchmesser des Substrats entspricht. Sollte eine Verfolgung des Bondfortschritts durch Leitfähigkeitsmessungen über die Oberfläche gemessen werden, kann der Bondfortschritt auch über den prozentuellen Anteil der gebondeten bzw. nicht gebondeten Oberfläche erfolgen. Die erfindungsgemäße Überwachung des Bondfortschritts erfolgt dann insbesondere solange, bis mehr als 1%, vorzugsweise mehr als 4%, noch bevorzugter mehr als 9%, am bevorzugtesten mehr als 16%, am allerbevorzugtesten mehr als 25% der Fläche gebondet wurden. Alternativ erfolgt die Überwachung kontinuierlich.

Eine Steuerung des Prozessablaufs erfolgt vorzugsweise auf Grund von vorgegebenen/eingestellten oder einstellbaren Werten aus der Überwachung, die innerhalb der vorgenannten Wertebereiche liegen. Hieraus ergibt sich eine erste Wartezeit für das Fortschreiten der Bondwelle und bis zum Einleiten des nächsten Prozessschrittes.

In einem siebten Prozessschritt erfolgt insbesondere eine Abschaltung der Fixierung des oberen, ersten Probenhalters. Denkbar wäre auch, dass das obere, erste Substrat durch eine gezielte Aufhebung der Fixierung, gelöst wird. Insbesondere bei Vakuumfixierungen, die aus mehreren einzeln ansteuerbaren Vakuumbahnen bestehen, erfolgt die gezielte Aufhebung der Fixierung durch eine kontinuierliche Aufhebung des Vakuums, insbesondere vom Zentrum zum Rand. Der siebte Prozessschritt wird insbesondere zu einem Zeitpunkt t₁ eingeleitet, an dem einer der Parameter der Messmittel einen vorgegebenen/eingestellten oder einstellbaren Wert erreicht (siehe insbesondere sechster Prozessschritt).

Allgemeiner oder anders ausgedrückt wird zu einem Zeitpunkt t₁ während des Bondens die Haltekraft F_{H1} reduziert, insbesondere so weit, dass sich das erste Substrat vom ersten Probenhalter löst.

In einem achten Prozessschritt erfolgt insbesondere eine erneute oder weitergehende Überwachung der Ausbreitung der fortschreitenden Bondwelle durch die Messmittel. Die Überwachung verfolgt den Fortschritt der Bondwelle und damit den Fortschritt des Bondvorgangs, vorzugsweise über einen Zeitraum von mehr als 5s, vorzugsweise mehr als 10s, noch bevorzugter mehr als 50s, am bevorzugtesten mehr als 75s, am allerbevorzugtesten mehr als 90s. Anstatt der Verfolgung des Bondvorgangs über ein Zeitintervall kann die Verfolgung der Bondwelle auch über die, insbesondere radiale, Position der Bondwelle gemessen werden. Die Verfolgung des Bondvorgangs erfolgt dabei insbesondere solange, bis sich die Bondwelle an einer radialen Position befindet die mindestens 0.3 mal, vorzugsweise mindestens 0.4 mal, noch bevorzugter mindestens 0.5 mal, am bevorzugtesten 0.6 mal, am allerbevorzugtesten 0.7 mal dem Durchmesser des Substrats entspricht. Sollte eine Verfolgung des Bondfortschritts durch Leitfähigkeitsmessungen über die Oberfläche möglich sein, kann der Bondfortschritt auch über den prozentuellen Anteil der gebondeten bzw. nicht gebondeten Oberfläche erfolgen. Die erfindungsgemäße Überwachung des Bondfortschritts erfolgt dabei solange, bis mehr als 9%, vorzugsweise mehr als 16%, noch bevorzugter mehr als 25%, am bevorzugtesten mehr als 36%, am allerbevorzugtesten mehr als 49% der Fläche gebondet wurden. Alternativ erfolgt die Überwachung kontinuierlich.

Eine Steuerung des Prozessablaufs erfolgt vorzugsweise auf Grund von vorgegebenen/eingestellten oder einstellbaren Werten aus der Überwachung, die innerhalb der vorgenannten Wertebereiche liegen. Hieraus ergibt sich eine zweite Wartezeit für das Fortschreiten der Bondwelle und bis zum Einleiten des nächsten Prozessschrittes.

In einem neunten Prozessschritt wird die Anwendung des Verformungsmittels gestoppt. Handelt es sich bei dem Verformungsmittel um einen Stift, wird der Stift zurückgezogen. Handelt es sich bei dem Verformungsmittel um eine oder mehrere Düsen, wird der Fluidstrom abgebrochen. Handelt es sich bei dem Verformungsmittel um elektrische und/oder magnetische Felder, werden diese abgeschaltet. Der neunte Prozessschritt wird insbesondere zu einem Zeitpunkt eingeleitet, an dem einer der Parameter der Messmittel einen vorgegebenen/eingestellten oder einstellbaren Wert erreicht (siehe insbesondere achter Prozessschritt).

In einem zehnten Prozessschritt erfolgt eine erneute oder weitergehende Überwachung der Ausbreitung der fortschreitenden Bondwelle. Die Überwachung verfolgt den Fortschritt der Bondwelle und damit den Fortschritt des Bondvorgangs, vorzugsweise über einen Zeitraum von mehr als 5s, vorzugsweise mehr als 10s, noch bevorzugter mehr als 50s, am bevorzugtesten mehr als 75s, am allerbevorzugtesten mehr als 90s. Anstatt der Verfolgung des Bondvorgangs über ein Zeitintervall kann die Verfolgung der Bondwelle auch über die, insbesondere radiale, Position der Bondwelle angegeben werden. Die Verfolgung des Bondvorgangs erfolgt dabei solange, bis sich die Bondwelle an einer radialen Position befindet die mindestens 0.6 mal, vorzugsweise mindestens 0.7 mal, noch bevorzugter mindestens 0.8 mal, am bevorzugtesten 0.9 mal dem Durchmesser des Substrats entspricht. Soweit die Substrate ein Kantenprofil besitzen, ist es nicht möglich, die Verfolgung des Bondvorgangs bis zum äußersten Rand zu verfolgen, da ca. 3-5 mm auf Grund des Kantenprofils nicht verbondet werden. Sollte eine Verfolgung des Bondfortschritts durch Leitfähigkeitsmessungen über die Oberfläche möglich sein, dann kann der Bondfortschritt auch über den prozentuellen Anteil der gebondeten bzw. nicht gebondeten Oberfläche erfolgen. Die erfindungsgemäße Überwachung des Bondfortschritts erfolgt dabei solange, bis mehr als 36%, vorzugsweise mehr als 49%, noch bevorzugter mehr als 64%, am bevorzugtesten mehr als 81%, am allerbevorzugtesten mehr als 100% der Fläche gebondet wurden. Alternativ erfolgt die Überwachung kontinuierlich.

Eine Steuerung des Prozessablaufs erfolgt vorzugsweise auf Grund von vorgegebenen/eingestellten oder einstellbaren Werten aus der Überwachung, die innerhalb der vorgenannten Wertebereiche liegen. Hieraus ergibt sich eine dritte Wartezeit für das Fortschreiten der Bondwelle und bis zum Einleiten des nächsten Prozessschrittes.

Ein Beispiel für einen Prozessablauf der ersten Ausführungsform wird nachfolgend wiedergegeben:
- Laden der Substrate
- Pin in Kontakt mit dem Wafer bringen (Kraft auf den Wafer 100mN), ohne den Bond zu starten
- Relative Annäherung beider Wafer zueinander(Abstand 40-200µm)
- Kraftbeaufschlagung des Wafers, um einen Fusion-Bond zwischen den beiden Substraten zu initiieren (Kraft 1500-2800mN)
- Heizung deaktivieren
- Warten, bis sich die Bondwelle genügend weit ausgebreitet hat (typischerweise 1-5s) - Wartezeit 1
- Abschalten (exhaust) des Top Wafer Haltevakuums (insbesondere beide Zonen gleichzeitig).
- Warten, bis sich die Bondwelle weiter ausgebreitet hat (insbesondere 2-15s) - Wartezeit 3
- Zurückziehen des Pins
- Warten, bis sich die Bondwelle vollständig ausgebreitet hat (insbesondere 5-90s) - Wartezeit 4

Die einzelnen Verfahrensschritte können durch die oben beschriebene allgemeine technische Lehre verallgemeinert werden.

### Prozess gemäß zweiter Ausführungsform der Erfindung

Der Prozess gemäß der zweiten Ausführungsform entspricht vom ersten bis einschließlich zum siebten Prozessschritt der ersten Ausführungsform.

In einem achten Prozessschritt erfolgt eine Reduzierung der Haltekraft oder eine Abschaltung der Fixierung des unteren, zweiten Probenhalters. Denkbar wäre auch, dass das untere, zweite Substrat durch eine gezielte Aufhebung der Fixierung, gelöst wird. Insbesondere bei Vakuumfixierungen, die aus mehreren einzeln ansteuerbaren Vakuumbahnen bestehen, erfolgt die gezielte Aufhebung der Fixierung vorzugsweise durch eine kontinuierliche Aufhebung des Vakuums, insbesondere vom Zentrum zum Rand. Der erfindungsgemäße achte Prozessschritt ist ein wichtiger Vorgang zur Reduzierung des "run-out" Fehlers. Durch die Reduzierung der Haltekraft oder eine Abschaltung der Fixierung des unteren, zweiten Probenhalters wird es dem unteren/zweiten Substrat erfindungsgemäß ermöglicht, sich dem oberen, ersten Substrat anzupassen. Durch das Wegfallen der Fixierung erfolgt quasi eine Aufhebung einer zusätzlichen (mathematisch-mechanischen) Randbedingungen, welche den Vorgang des Bondens beschränken würde.

Allgemeiner oder anders ausgedrückt wird zu einem Zeitpunkt t₂ während des Bondens eine Haltekraft F_{H2} reduziert, insbesondere so weit, dass sich das zweite Substrat auf dem zweiten Probenhalter verformen kann.

Ein neunter Prozessschritt entspricht dem achten Prozessschritt der ersten Ausführungsform.

In einem erfindungsgemäßen zehnten Prozessschritt wird das zweite, insbesondere bereits teilweise gebondete, Substrat am unteren, zweiten Probenhalters wieder fixiert. Der erfindungsgemäße zehnte Prozessschritt ist ebenfalls ein wichtiger Vorgang zur Reduzierung des "run-out" Fehlers. Durch eine erneute Fixierung, insbesondere ein erneutes Einschalten des Haltevakuums wird der Fortgang des Bondens wieder durch die (mathematisch-mechanische) Randbedingung beschränkt.

Allgemeiner oder anders ausgedrückt wird zu einem Zeitpunkt t₄, insbesondere nach dem Bonden, die Haltekraft F_{H2} erhöht.

Ein elfter entspricht dem neunten und ein zwölfter entspricht dem zehnten Prozessschritt gemäß der ersten Ausführungsform.

In einer ganz speziellen erfindungsgemäßen Ausführungsform kann das Abschalten der Fixierung gemäß Prozessschritt 8 und das erneute Einschalten der Fixierung gemäß Prozessschritt 10 vor dem Abschluss des Bondvorganges mehrmals wiederholt werden. Insbesondere ist es sogar möglich, die Abschaltung und erneute Fixierung ortsaufgelöst durchzuführen. Das funktioniert erfindungsgemäß vor allem mit den bereits in der Offenbarung erwähnten, einzeln ansteuerbaren Vakuumbahnen bzw. Vakuumsegmenten. Im idealsten Fall wird also eine orts- und/oder zeitaufgelöste Aufhebung bzw. Fixierung des unteren/zweiten Substrats durchgeführt.

Ein Beispiel für einen Prozessablauf der zweiten Ausführungsform wird nachfolgend wiedergegeben:
- Laden der Substrate
- Pin (Verformungsmittel) in Kontakt mit dem Wafer bringen (insbesondere Kraft auf den Wafer von 100mN), ohne den Bond zu starten - Pin Kraft 1
- Relative Annäherung beider Wafer zueinander (insbesondere Abstand 40-200µm) - Abstand 1
- Drücken auf den Wafer, um einen Fusion-Bond zwischen den beiden Substraten zu initiieren (insbesondere Kraft 1500-2800mN) - Pin Kraft 2
- Heizung deaktivieren
- Warten, bis sich die Bondwelle genügend weit ausgebreitet hat (insbesondere 1-5s) - Wartezeit 1
- Abschalten (exhaust) des Haltevakuums für den oberen Wafer (insbesondere beide Zonen gleichzeitig)
- Abschalten (exhaust) des Haltevakuums für den unteren Wafer
- Warten, bis sich die Bondwelle weiter ausgebreitet hat (insbesondere 2-15s) - Wartezeit 3
- Einschalten des Haltevakuums für den unteren Wafer - Vakuum 1
- Zurückziehen des Pins
- Warten, bis sich die Bondwelle vollständig ausgebreitet hat (insbesondere 5-90s) - Wartezeit 4

Die einzelnen Verfahrensschritte können durch die oben beschriebene allgemeine technische Lehre verallgemeinert werden.

### Prozess gemäß dritter Ausführungsform der Erfindung

Der Prozess gemäß der dritten Ausführungsform entspricht vom ersten bis einschließlich zum neunten Prozessschritt der zweiten Ausführungsform. Im neunten Prozessschritt werden die Parameter vorzugsweise um 10 bis 40% niedriger angesetzt als bei der zweiten Ausführungsform. Hierdurch wird die Wartezeit bis zum zehnten Prozessschritt reduziert, wobei bei der dritten Ausführungsform eine zusätzliche Wartezeit eingeführt wird beziehungsweise die zweite Wartezeit geteilt wird.

In einem erfindungsgemäßen zehnten Prozessschritt erfolgt eine Belüftung des Raumes zwischen dem unteren, zweiten Probenhalter und dem darauf praktisch nicht fixiert aufliegenden, unteren/zweiten Substrat auf einen definierten Druck. Unter Druck ist hierbei der Absolutdruck zu verstehen. Ein Absolutdruck von 1 bar entspricht dabei dem Atmosphärendruck. Um den erfindungsgemäßen Vorgang durchzuführen, muss die Kammer also vorher evakuiert und danach zur Atmosphäre geöffnet, also belüftet, werden. Hierdurch wird die freie Beweglichkeit des Substrats begünstigt, so dass Verzerrungen gegenüber dem ersten Substrat weiter minimiert werden. Der Druck beträgt insbesondere zwischen 1 mbar und 1000 mbar, vorzugsweise zwischen 2.5 mbar und 800 mbar, noch bevorzugter zwischen 5 mbar und 600 mbar, am bevorzugtesten zwischen 7.5 mbar und 400 mbar, am allerbevorzugtesten zwischen 10 mbar und 200 mbar. In einer weiteren erfindungsgemäßen Ausführungsform ist es denkbar, dass die erfindungsgemäße Ausführungsform bis zum genannten zehnten Prozessschritt unter Atmosphärendruck stattfindet und danach durch einen Kompressor ein Überdruck in der Kammer erzeugt wird. Der Druck liegt in diesem Fall insbesondere zwischen 1 bar und 3 bar, vorzugsweise zwischen 1 bar und 2.5 bar, noch bevorzugter zwischen 1 bar und 2 bar, am bevorzugtesten zwischen 1 bar und 1.5 bar, am allerbevorzugtesten zwischen 1 bar und 1.2 bar.

In einem elften Prozessschritt erfolgt insbesondere eine erneute oder weitergehende Überwachung der Ausbreitung der fortschreitenden Bondwelle durch die Messmittel. Die Überwachung verfolgt den Fortschritt der Bondwelle und damit den Fortschritt des Bondvorgangs über einen Zeitraum von mehr als 1 s, vorzugsweise mehr als 2s, noch bevorzugter mehr als 5s, am bevorzugtesten mehr als 10s, am allerbevorzugtesten mehr als 15s. Anstatt der Verfolgung des Bondvorgangs über ein Zeitintervall, kann die Verfolgung der Bondwelle auch über die, insbesondere radiale, Position der Bondwelle angegeben werden. Die Verfolgung des Bondvorgangs erfolgt dabei solange, bis sich die Bondwelle an einer radialen Position befindet die mindestens 0.3 mal, vorzugsweise mindestens 0.4 mal, noch bevorzugter mindestens 0.5 mal, am bevorzugtesten 0.6 mal, am allerbevorzugtesten 0.7 mal dem Durchmesser des Substrats entspricht. Sollte eine Verfolgung des Bondfortschritts durch Leitfähigkeitsmessungen über die Oberfläche messbar sein, dann kann der Bondfortschritt auch über den prozentuellen Anteil der gebondeten bzw. nicht gebondeten Oberfläche erfolgen. Die erfindungsgemäße Überwachung des Bondfortschritts erfolgt dabei solange, bis mehr als 9%, vorzugsweise mehr als 16%, noch bevorzugter mehr als 25%, am bevorzugtesten mehr als 36%, am allerbevorzugtesten mehr als 49% der Fläche gebondet wurden. Alternativ erfolgt die Überwachung kontinuierlich.

Eine Steuerung des Prozessablaufs erfolgt vorzugsweise auf Grund von vorgegebenen/eingestellten oder einstellbaren Werten aus der Überwachung, die innerhalb der vorgenannten Wertebereiche liegen. Hieraus ergibt sich eine erste Wartezeit für das Fortschreiten der Bondwelle und bis zum Einleiten des nächsten Prozessschrittes.

In einem erfindungsgemäßen zwölften Prozessschritt wird das zweite, insbesondere bereits teilweise gebondete, Substrat am unteren, zweiten Probenhalters wieder fixiert.

Allgemeiner oder anders ausgedrückt wird zu einem Zeitpunkt t₄, insbesondere nach dem Bonden, die Haltekraft F_{H2} erhöht.

Ein dreizehnter entspricht dem neunten und ein vierzehnter entspricht dem zehnten Prozessschritt der ersten Ausführungsform.

Ein Beispiel für einen Prozessablauf der dritten Ausführungsform wird nachfolgend wiedergegeben:
- Laden der Substrate
- Pin in Kontakt mit dem Wafer bringen (insbesondere Kraft auf den Wafer 100mN), ohne den Bond zu starten - Pin Kraft 1
- Relative Annäherung beider Wafer zueinander (insbesondere Abstand 40-200µm) - Abstand 1
- Drücken auf den Wafer, um einen Fusion-Bond zwischen den beiden Substraten zu initiieren (insbesondere Kraft 1500-2800mN) - Pin Kraft 2
- Heizung deaktivieren
- Warten, bis sich die Bondwelle genügend weit ausgebreitet hat (insbesondere 1-5s) - Wartezeit 1
- Abschalten (exhaust) des Haltevakuums für den oberen Wafer (insbesondere beide Zonen gleichzeitig)
- Abschalten (exhaust) des Haltevakuums für den unteren Wafer
- Warten, bis sich die Bondwelle weiter ausgebreitet hat (insbesondere 1-10s) - Wartezeit 2
- Belüften des Volumens zwischen unteren Wafer und dem Chuck (unterer Probenhalter) für einen definierten Zeitraum mit definiertem Druck (insbesondere 10-200mbar) - Druck 1
- Warten, bis sich die Bondwelle weiter ausgebreitet hat (insbesondere 2-15s) - Wartezeit 3
- Einschalten des Haltevakuums für den unteren Wafer - Vakuum 1
- Zurückziehen des Pins
- Warten, bis sich die Bondwelle vollständig ausgebreitet hat (insbesondere 5-90s) - Wartezeit 4.

Die einzelnen Verfahrensschritte können durch die oben beschriebene allgemeine technische Lehre verallgemeinert werden.

### Post-Processing

Die beschriebenen Prozesse können, insbesondere in weiteren Prozessmodulen, weitergeführt werden.

In einer ersten, denkbaren Weiterführung, wird der erzeugte Substratstapel, insbesondere in einem Metrology-Modul, untersucht. Die Untersuchung umfasst vor allem Messungen des Bondinterfaces zur Feststellung von:
- Ausrichtungsfehlern, insbesondere
   ∘ globalen Ausrichtungsfehlern und/oder
   ∘ run-out Fehlern und/oder
- Defekten, insbesondere
   ∘ Voids und/oder
   ∘ Blasen (engl.: bubbles) und/oder
   ∘ Rissen.

Sollte die Inspektion des Substratstapels nicht tolerierbare Fehler aufweisen, so wird der Substratstapel vorzugsweise wieder getrennt. Die Trennung erfolgt dabei vorzugsweise mit Prozessen und Anlagen, die in den Druckschriften EP2697823B1 und WO2013/091714A1 offenbart wurden. Hierauf wird insofern Bezug genommen. Die Untersuchung des Bondinterfaces erfolgt insbesondere vor einer weiteren Wärmebehandlung.

In einer zweiten, denkbaren Weiterführung, wird der erzeugte Substratstapel wärmebehandelt. Die Wärmebehandlung führt insbesondere zu einer Verstärkung des erzeugten Bonds zwischen den Substraten des Substratstapels. Die Wärmebehandlung erfolgt insbesondere bei einer Temperatur höher als 25°C, vorzugsweise höher als 100°C, noch bevorzugter höher als 250°C, am bevorzugtesten höher als 500°C, am allerbevorzugtesten höher als 750°C. Die Temperatur entspricht im Wesentlichen der Heiztemperatur T_{H}. Die erzeugte Bondstärke ist insbesondere größer als 1.0 J/m², vorzugsweise größer als 1.5 J/m², noch bevorzugter größer als 2.0 J/m², am allerbevorzugtesten größer als 2.5 J/m². Die Wärmebehandlung findet vorzugsweise unter Vakuum statt. Der Vakuumdruck ist insbesondere kleiner als 1 bar, vorzugsweise kleiner als 800 mbar, noch bevorzugter kleiner als 10⁻³ mbar, am bevorzugtesten kleiner als 10⁻⁵ mbar, am allerbevorzugtesten kleiner als 10⁻⁸ mbar.

Denkbar ist allerdings auch, dass die Wärmebehandlung in einer Schutzgasatmosphäre durchgeführt wird. Das ist insbesondere dann von Vorteil, wenn die verwendeten Schutzgase die Wärmeübertragung erleichtern. Die Wärmeleitfähigkeit der Schutzgase ist insbesondere größer als 0 W/(m*K), vorzugsweise größer als 0.01 W/(m*K), noch bevorzugter größer als 0.1 W/(m*K), am bevorzugtesten größer als 1 W/(m*K). Die Wärmeleitfähigkeit von Helium liegt beispielsweise ca. zwischen 0.15 W/(m*K) und 0.16 W/(m*K). Bei den Schutzgasen handelt es sich insbesondere um:
- Edelgase, insbesondere Helium, Neon, Argon, Krypton und/oder Xenon
- Molekulare Gase, insbesondere Kohlendioxid und/oder Stickstoff
- Beliebige Kombination aus den vorgenannten Gasen.

Bevorzugt weisen die Substrate annähernd identische Durchmesser D1, D2 auf, die insbesondere um weniger als 5 mm, vorzugsweise weniger als 3 mm, noch bevorzugter weniger als 1 mm, voneinander abweichen.

Gemäß einem weiteren, insbesondere eigenständigen, Erfindungsaspekt erfolgt die Verformung durch mechanische Stellmittel und/oder durch Temperatursteuerung der ersten und/oder zweiten Aufnahmeeinrichtungen.

Indem das erste Substrat und/oder das zweite Substrat ausschließlich im Bereich der Seitenwände an den ersten und/oder zweiten Aufnahmeflächen fixiert wird/werden, ist die erfindungsgemäße Verformung leichter realisierbar.

Die Ergebnisse der erfindungsgemäßen Prozesse sind abhängig von einer Vielzahl physikalischer Parameter, die direkt den Substraten oder der Umgebung zugeordnet werden können. Im weiteren Verlauf der Offenbarung werden die wichtigsten Parameter und deren Einfluss auf den "run-out" Fehler beschrieben. Die Parameter werden grob eingeteilt in Einzelparameter und Paarparameter. Ein Einzelparameter kann keiner Symmetrieseite, insbesondere keinem Substrat, zugeordnet werden. Ein Paarparameter kann auf einer Symmetrieseite, insbesondere einem ersten Substrat, einen anderen Wert besitzen als auf der jeweils gegenüberliegenden Symmetrieseite, insbesondere einem zweiten Substrat. Es gibt eine erste, obere Symmetrieseite und eine zweite, untere Symmetrieseite. Ein Beispiel für einen Einzelparameter ist die Bondwellengeschwindigkeit v oder der Gas(gemisch)druck p. Ein Beispiel für einen Paarparameter sind die Substratdicken d1 und d2.

Wird im weiteren Verlauf die Beeinflussung eines Paarparameters auf das Bondresultat beschrieben, wird, soweit nicht anders erwähnt, davon ausgegangen, dass alle anderen Werte eines jeden Paarparameters vorzugsweise gleich sind. Folgendes Beispiel sei exemplarisch genannt. Wird der Einfluss zweier unterschiedlicher Substratdicken d1 und d2 auf das Bondresultat beschrieben, wird davon ausgegangen, dass die beiden E-Moduli E1 und E2 der beiden Substrate gleich sind.

Ziel ist es, den "run-out" Fehler durch eine optimale, berechnete und/oder empirisch ermittelte, insbesondere von der Zeit abhängige, Biegelinie zu minimieren bzw. gänzlich zu eliminieren. Unter Biegelinie ist dabei die symmetriereduzierte, Darstellung einer eindimensionalen Funktion zu verstehen, welche die Oberflächenpositionen eines Substrats, die Substratoberfläche, als Funktion der Ortskoordinate, insbesondere einer Radialkoordinate, abbildet. Symmetriereduziert bedeutet, dass auf Grund der radialsymmetrischen Symmetrie der beiden Substrate die Berechnung der eindimensionalen Biegelinie ausreicht um Rückschlüsse auf die zweidimensionale Kontaktierung der Substrate zueinander zu erhalten, die den genannten minimalen oder vollständig eliminierten "run-out" Fehler erzeugt. Einfach ausgedrückt, kann man die Biegelinie eines Substrats beschreiben als die, insbesondere dem Bondinterface zugewandte,

Substratoberfläche. Vorzugsweise gilt die Beschreibung der Biegelinie für das erste Substrat analog für das zweite Substrat.

Die Biegelinien, d.h. die Substratoberflächen, werden erfindungsgemäß insbesondere durch einen oder mehrere der folgenden Parameter maßgeblich beeinflusst.

Die Substratdicken d1, d2 sind über die Volumina V1 und V2 und die Dichten ρ1, ρ2 mit den Massen m1, m2 und damit den Gewichtskräften G1, G2 der beiden Substrate verbunden. Die Gewichtskraft G1 des ersten Substrats hat einen direkten Einfluss auf das Beschleunigungsverhalten des ersten, oberen Substrats in Richtung des zweiten, unteren Substrats. Bei ausgeschalteter unterer Fixierung ist die Gewichtskraft G2 ein Maß für die Trägheitskraft des zweiten, unteren Substrats und damit ein Maß für das Bestreben des zweiten, unteren Substrats sich entlang der Bondwelle dem ersten, oberen Substrat entgegen zu bewegen oder zu halten oder liegen zu bleiben.

Die E-Moduli E1, E2 sind ein Maß für die Steifigkeit der Substrate. Sie tragen entscheidend zur Biegelinie bei und definieren damit die Funktion mit, mit deren Hilfe sich beschreiben lässt, wie sich die Substrate aufeinander zu bewegen.

Die Kräfte F1 und F2 haben einen Einfluss auf die Fläche, mit der die beiden Substrate, insbesondere zentrisch, miteinander verbunden werden. Da es eine punktförmige Kontaktierung nur im Idealfall gibt, muss immer davon ausgegangen werden, dass die Kontaktierung der beiden Substrate im Zentrum an einer Fläche erfolgt. Die Größe der Fläche wird maßgeblich durch die Kräfte F1 und F2 festgelegt. Die Größe der Kontaktfläche ist entscheidend für die Randbedingung.

Durch die Temperaturen T1, T2 der beiden Substrate kann der globale thermische Dehnungszustand der Substrate beeinflusst werden. Es kann erfindungsgemäß somit festgelegt werden, wie stark sich die Substrate in Bezug zu einer Referenztemperatur global, durch thermische Dehnungen, verzerren. Die korrekte Temperierung des oberen und/oder unteren Substrats ist daher ein wesentlicher Aspekt für eine möglichst korrekte und vollständige "run-out" Kompensation. Vorzugsweise können die Temperaturen beider Substrate unterschiedlich eingestellt werden. Die Temperaturen werden insbesondere so eingestellt, dass sich die Substrate in einem Dehnungszustand befinden, in dem die zueinander zu verbondenden Strukturen kongruent zueinander sind, d.h. der "run-out" Fehler verschwindet (unter der Annahme, dass beim Bonden durch die bereits weiter oben genannten Parameter nicht ein zusätzlicher "run-out" Fehler eingebaut wird). Die hierzu notwendigen Temperaturen können durch Messmittel und/oder empirisch bestimmt werden.

Der Gas(gemisch)druck p beeinflusst den Widerstand, den die Atmosphäre den sich aufeinander zubewegenden Substraten entgegensetzt. Durch den Gas(gemisch)druck kann direkter Einfluss auf die Bondwellengeschwindigkeit v genommen werden. Es wird insofern auf die Druckschrift WO2014191033A1 Bezug genommen.

Haltekräfte F_{H1}, F_{H2} dienen vor allem der Fixierung der Substrate vor dem eigentlichen Bondvorgang. Die Haltekraft F_{H1} ist eine Randbedingung für die Prozessschritte 1 bis inklusive 6, verliert nach dem Ausschalten der Fixierung allerdings den Einfluss einer, die Biegelinie bestimmenden, Randbedingung. Ebenso wird die Haltekraft F_{H2} nur für den Zeitpunkt einer aktiven, unteren Fixierung als Randbedingung hinzugezogen. Für elastizitätstheoretische Berechnungen müssen daher spätestens ab dem Prozessschritt 7 entsprechend neue Randbedingungen formuliert werden.

Ausgangskrümmungsradien r₁₀, r₂₀ sind die Ausgangsradien der Substrate vor dem erfindungsgemäßen Prozess. Sie sind Funktionen des Ortes, insbesondere aber konstant bezüglich des Ortes. In einer besonderen ersten erfindungsgemäßen Ausführungsform ist der Anfangskrümmungsradius r₁₀ des zweiten, unteren Substrats unendlich groß, da das zweite untere Substrat am Beginn des erfindungsgemäßen Prozesses eben aufliegt. In einer weiteren besonderen zweiten erfindungsgemäßen **Ausführungsform** ist der Anfangskrümmungsradius r₁₀ des zweiten, unteren Substrats eine endliche, positive oder negative Konstante, entsprechend einer konstanten konvexen oder konkaven Krümmung. In diesem Fall liegt das zweite untere Substrat am Beginn des erfindungsgemäßen Prozesses in konvexer oder konkav gekrümmter Form vor. Ein derartiger Probenhalter wird in der Druckschrift WO2014191033A1 beschrieben, auf die insofern Bezug genommen wird. Insbesondere entspricht zumindest der Ausgangskrümmungsradius r₁₀ des zweiten, unteren Substrats einem Probenhalterkrümmungsradius der Oberfläche des zweiten, unteren Probenhalters, auf dem das zweite Substrat aufliegt.

Substratkrümmungsradien r1, r2 der beiden Substrate entlang der Bondwelle sind ein Resultat der Lösung der elastizitätstheoretischen Gleichungen unter Berücksichtigung der genannten Parameter. Sie sind insbesondere Funktionen des Ortes und der Zeit.

Die Bondwellengeschwindigkeit ist ein Resultat der oben genannten Parameter.

Weitere bevorzugte Ausführungsformen:
Die Reduzierung der Heiztemperatur T_{H} erfolgt bevorzugt abhängig vom Verlauf der Bondwelle, insbesondere durch Abschalten einer Heizung.

Der Verlauf der Bondwelle wird bevorzugt durch Messmittel zumindest abschnittsweise erfasst wird.

Zu einem Zeitpunkt t₁ wird bevorzugt während des Bondens die Haltekraft F_{H1} reduziert, insbesondere so weit, dass sich das erste Substrat (2) vom ersten Probenhalter (1) löst.

Zu einem Zeitpunkt t₂ während des Bondens wird bevorzugt die Haltekraft F_{H2} reduziert, insbesondere so weit, dass sich das zweite Substrat (2') auf dem zweiten Probenhalter (1') entlang der zweiten Probenhalteroberfläche (2o' verformen kann.

Das zweite Substrat (2') wird bevorzugt zu einem Zeitpunkt t₃ von der zweiten Probenhalteroberfläche (1o') her mit einem Überdruck, insbesondere zwischen 10 mbar und 500 mbar, vorzugsweise zwischen 10 mbar und 200 mbar, belüftet.

Zu einem Zeitpunkt t₄, insbesondere nach dem Bonden, wird bevorzugt die Haltekraft F_{H2} erhöht.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1a: eine schematische, nicht maßstabsgetreue Querschnittsdarstellung eines ersten Prozessschrittes einer ersten Ausführungsform eines erfindungsgemäßen Verfahrens,
- Figur 1b: eine schematische, nicht maßstabsgetreue Querschnittsdarstellung eines zweiten Prozessschrittes,
- Figur 1c: eine schematische, nicht maßstabsgetreue Querschnittsdarstellung eines dritten Prozessschrittes,
- Figur 1d: eine schematische, nicht maßstabsgetreue Querschnittsdarstellung eines vierten Prozessschrittes,
- Figur 1e: eine schematische, nicht maßstabsgetreue Querschnittsdarstellung eines fünften Prozessschrittes,
- Figur 1f: eine schematische, nicht maßstabsgetreue Querschnittsdarstellung eines sechsten Prozessschrittes,
- Figur 1g: eine schematische, nicht maßstabsgetreue Querschnittsdarstellung eines siebten Prozessschrittes,
- Figur 1h: eine schematische, nicht maßstabsgetreue Querschnittsdarstellung eines achten Prozessschrittes,
- Figur 1i: eine schematische, nicht maßstabsgetreue Querschnittsdarstellung eines neunten Prozessschrittes,
- Figur 1j: eine schematische, nicht maßstabsgetreue Querschnittsdarstellung eines zehnten Prozessschrittes,
- Figur 2: eine schematische, nicht maßstabsgetreue Querschnittsdarstellung eines zusätzlichen Prozessschrittes einer dritten Ausführungsform des erfindungsgemäßen Verfahrens,
- Figur 3: eine schematische, nicht maßstabsgetreue Querschnittsdarstellung eines optionalen zusätzlichen Prozessschrittes und
- Figur 4: eine schematische, nicht maßstabsgetreue Querschnittsdarstellung zweier Substrate.

In den Figuren sind gleiche Bauteile und Bauteile mit der gleichen Funktion mit den gleichen Bezugszeichen gekennzeichnet.

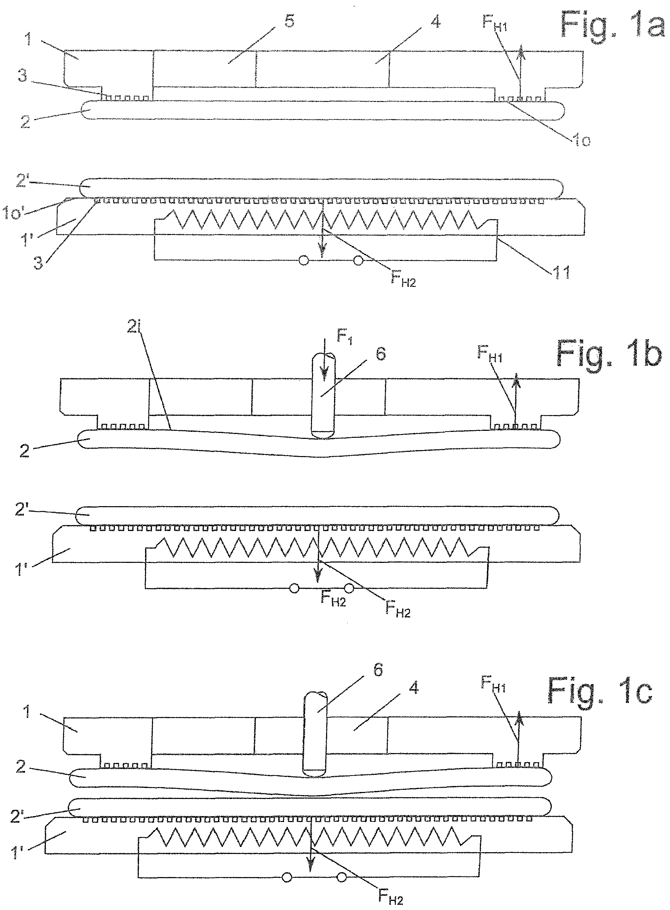

Die Figur 1a zeigt einen ersten Prozessschritt, bei dem ein erstes, insbesondere oberes, Substrat 2 an einer Probenhalteroberfläche 1o eines ersten, insbesondere oberen, Probenhalters 1 fixiert wurde. Die Fixierung erfolgt über Fixiermittel 3 mit einer Haltekraft F_{H1}.

Der erste Probenhalter 1 besitzt eine, insbesondere zentrische, Durchgangsöffnung, insbesondere Bohrung 4. Die Durchgangsöffnung dient zur Durchführung eines Verformungsmittels 4 zur Verformung des ersten Substrats 2.

In einer vorteilhaften, hier gezeigten Ausführungsform, verfügt der erste Probenhalter 1 über Löcher 5, durch welche eine Beobachtung des Bondfortschritts durch Messmittel erfolgen kann. Bei dem Loch 5 handelt es sich vorzugsweise um eine längliche Ausfräsung.

Auf einem zweiten, insbesondere unteren, Probenhalter 1' wird ein zweites Substrat 2' geladen und fixiert. Die Fixierung erfolgt über Fixiermittel 3' mit einer Haltekraft F_{H2}.

Bei den Fixiermitteln 3, 3' handelt es sich vorzugsweise um Vakuumfixierungen.

Die Probenhalter 1, 1' verfügen insbesondere über Heizungen 11 (Heizmittel). In den Figuren wird, der Übersichtlichkeit halber, nur im zweiten, unteren Probenhalter 1' eine Heizung 11 schematisch dargestellt.

Alle genannten Parameter oder Kräfte, welche die Eigenschaften der Substrate 2, 2' beschreiben oder beeinflussen, sind im Allgemeinen Funktionen des Ortes und/oder der Zeit.
Als Beispiel für einen Parameter werden die Temperaturen T1 und T2 der beiden Substrate 2, 2' genannt. Im Allgemeinen können die Temperaturen T1 bzw. T2 ortsabhängig sein, daher es existieren Temperaturgradienten. In diesem Fall ist es sinnvoll die Temperaturen als explizite Funktionen des Ortes und/oder der Zeit anzugeben.
Als Beispiel für eine Kraft werden die beiden Gravitationskräfte G1 und G2 genannt. Sie stellen in den Figuren die gesamte auf die Substrate 2, 2' wirkenden Gravitationskräfte dar. Dem Fachmann ist aber durchaus klar, dass die beiden Substrate 2, 2' in infinitesimale (Massen)teile dm zerlegt werden kann und dass der Einfluss der Gravitation auf jeden dieser Massenteile dm bezogen werden kann. Damit wäre die Gravitationskraft im Allgemeinen als Funktion des Ortes und/oder der Zeit anzugeben.

Analoge Überlegungen gelten für alle anderen Parameter und/oder Kräfte.

Die Figur 1b zeigt einen zweiten, erfindungsgemäßen Prozessschritt, bei dem das Verformungsmittel 4, insbesondere ein Stift, eine Rückseite 2i des ersten Substrats 2 mit einem Druck beaufschlagt, um eine Verformung des ersten Substrats 2 zu bewirken. Die Verformung des ersten Substrats 2 erfolgt dabei mit einer ersten Kraft F₁.

In einem Prozessschritt gemäß Figur 1c erfolgt eine relative Annäherung der beiden Probenhalter 1, 1' und damit der beiden Substrate 2,2' zueinander bis zu einem definierten Abstand. Die Annäherung kann auch während oder vor dem zweiten Prozessschritt erfolgen.

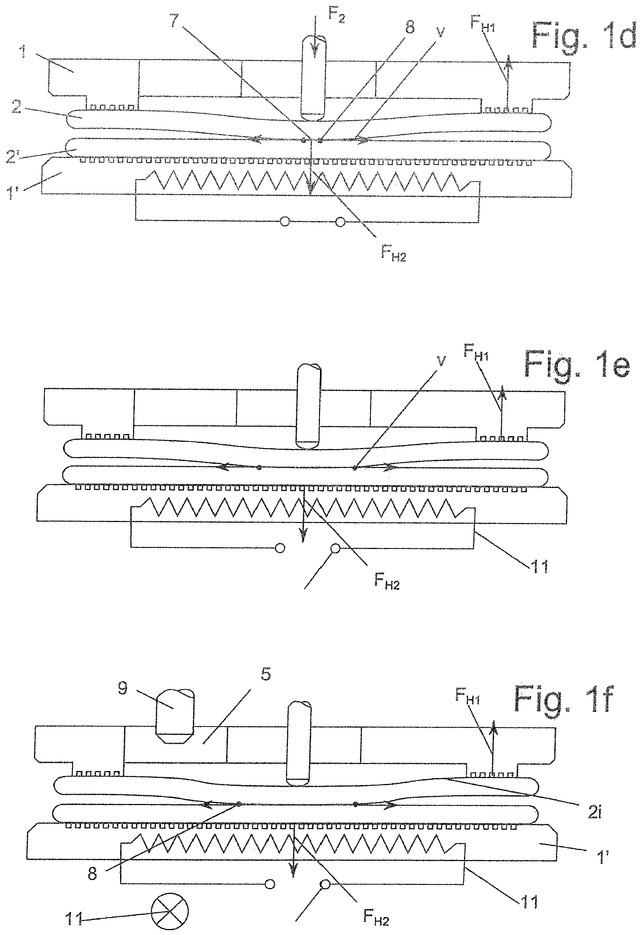

In einem Prozessschritt gemäß Figur 1d erfolgt die Initiierung des Bonds, insbesondere eines Pre-Bonds, mit einer zweiten Kraft F₂. Die zweite Kraft F₂ sorgt für eine weitere, insbesondere infinitesimal kleine Durchbiegung und weitere Annäherung der beiden Substrate 2, 2' und schließlich Kontaktierung in einem Kontaktpunkt 7.

Eine Bondwelle, genauer eine Bondwellenfront 8, beginnt sich mit einer Bondwellengeschwindigkeit v, insbesondere radialsymmetrisch, vorzugsweise konzentrisch, vom Kontaktpunkt 7 fortzupflanzen. Im Laufe der weiteren Prozessschritte kann sich die Bondwellengeschwindigkeit v ändern, sodass die Bondwellengeschwindigkeit v als Funktion des Ortes (bzw. der Zeit) definiert werden kann. Die Bondwellengeschwindigkeit v kann durch verschiedene Maßnahmen beeinflusst werden.

In einem weiteren Prozessschritt gemäß Figur 1e wird die Heizung 11 des ersten und/oder zweiten Probenhalters 1,1' ausgeschaltet und damit die weitere Erwärmung des ersten und/oder zweiten Substrats 2, 2' unterbrochen. In einem weiteren Prozessschritt gemäß Figur 1f erfolgt eine Überwachung der Bondwellenfront 8 mit Hilfe von Messmitteln 9, insbesondere mindestens einer Optik, vorzugsweise einer Infrarotoptik. Durch das (mindestens eines - Anzahl entspricht vorzugsweise der Anzahl der Optiken) Loch 5 können die Messmittel 9 die Substratrückseite 2i des ersten Substrats 2, noch bevorzugter das Bondinterface zwischen den beiden Substraten 2, 2', und somit die Bondwellenfront 8 erfassen. Die Erfassung des Bondinterfaces erfolgt insbesondere bei Messmitteln 9, die sensitiv für elektromagnetische Strahlung sind, welche ohne nennenswerte Schwächung die beiden Substrate 2, 2' durchdringen kann. Vorzugsweise wird eine Lichtquelle 12 oberhalb und/oder unterhalb und/oder innerhalb des Probenhalters 1' positioniert, deren elektromagnetische Strahlung den Probenhalter 1' und/oder die Substrate 2, 2' beleuchtet und/oder durchleuchtet und von dem Messmittel 9 detektiert werden kann. Die so aufgenommenen Bilder sind vorzugsweise Schwarz-Weiß Bilder. Die Helligkeitsunterschiede erlauben eine eindeutige Identifizierung der gebondeten von den nicht gebondeten Bereichen. Der Übergangsbereich beider Bereiche ist die Bondwelle. Durch eine derartige Vermessung kann insbesondere die Position der Bondwellenfront 8 und damit, insbesondere für mehrere derartige Positionen, auch die Bondwellengeschwindigkeit v ermittelt werden.

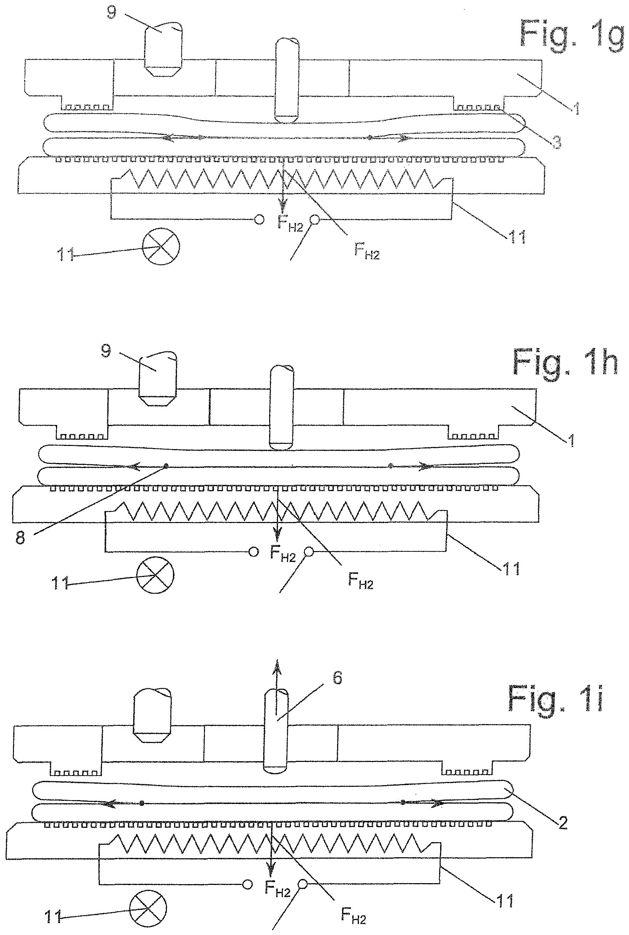

Die Figur 1g zeigt einen weiteren, siebten Prozessschritt, bei dem die Fixierung 3 des ersten Probenhalters 1 gelöst wird, indem die Haltekraft F_{H1} zumindest reduziert wird. Handelt es sich bei der Fixierung 3 um eine Vakuumfixierung, noch bevorzugter um eine Vakuumfixierung mit mehreren, separat steuerbaren Vakuumsegmenten (mit mehreren Haltekräften F_{H1}), erfolgt die Loslösung insbesondere von innen nach außen durch eine gezielte Abschaltung der Vakuumsegmente (oder Reduzierung der Haltekraft/Haltekräfte F_{H1}) von innen nach außen.

Die Figur 1h zeigt einen weiteren Prozessschritt, bei dem die Bondwellenfront 8 nach der Loslösung vom ersten Substrathalter 1 durch Messmittel 9 überwacht wird.

Die Figur 1i zeigt einen weiteren, Prozessschritt, bei dem die Einwirkung des Verformungsmittel 6 auf das erste Substrat 2 unterbrochen wird. Handelt es sich bei dem Verformungsmittel 6 um ein mechanisches Verformungsmittel, insbesondere einen Stift, erfolgt die Unterbrechung durch ein Zurückziehen. Bei der Verwendung von Düsen, erfolgt die Unterbrechung durch ein Abschalten des Fluidstroms. Bei elektrischen und/oder magnetischen Feldern, erfolgt die Unterbrechung durch ein Ausschalten der Felder.

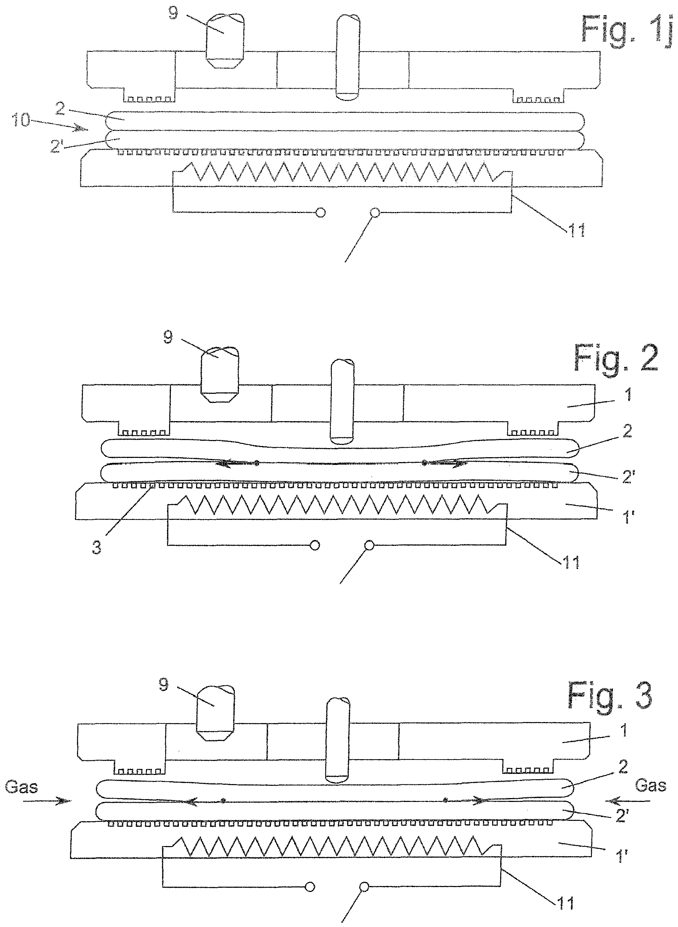

Die Figur 1j zeigt einen weiteren Prozessschritt, nach dem die beiden Substrate 2, 2' vollständig miteinander verbondet sind. Insbesondere erfolgt in diesem Prozessschritt eine weitere Überwachung der Bondwellenfront 8 (nicht mehr eingezeichnet, da in diesem Prozesszustand der Bond bereits abgeschlossen wurde) mit Hilfe der Messmittel 9 bis zum Ende des Bonds, an dem ein aus dem ersten und dem zweiten Substrat 2, 2' gebildeter Substratstapel 10 fertiggestellt ist.

Die Figur 2 zeigt einen optionalen Prozessschritt, bei dem, insbesondere nach dem Prozessschritt gemäß Figur 1g, eine Reduzierung der Haltekraft F_{H2} der zweiten, unteren Fixierung 3', des zweiten, unteren Probenhalters 1' erfolgt. Insbesondere wird die Haltekraft F_{H2} auf 0 reduziert, also die Fixierung deaktiviert Dies führt insbesondere dazu, dass sich das zweite Substrat 2' ungehindert bewegen kann, insbesondere in lateraler Richtung entlang der unteren Probenhalteroberfläche 1o'.

In einer weiteren, vorteilhaften Ausführungsform wird das zweite Substrat 2' entlang der Bondwellenfront 8 soweit angehoben, dass es sich vom zweiten, unteren Probenhalter 2', insbesondere lokal, abhebt. Dies wird insbesondere durch Beaufschlagung des zweiten Substrats 2' mit einem Druck vom zweiten Probenhalter 1' aus bewirkt.

Die Schwerkraft G2 wirkt während des gesamten Bondprozess der Anhebung des zweiten Substrats 2' entgegen und beeinflusst damit ebenfalls die Kontaktierung der beiden Substrate 2, 2' und damit den "run-out".

Die Figur 3 zeigt einen optionalen, erfindungsgemäßen Prozessschritt, bei dem die Kammer, in welcher der erfindungsgemäße Prozess abläuft, vor der Erzeugung des vollständig gebondeten Substratstapels 10, gelüftet wird. Die Belüftung dient insbesondere der Kontrolle der voranschreitenden Bondwellenfront 8. Eine genaue Beschreibung der Beeinflussungsmöglichkeiten ist in der Druckschrift WO2014/191033A1 offenbart, auf die insofern Bezug genommen wird. Die Belüftung erfolgt mit einem Gas oder Gasgemisch. Insbesondere erfolgt die Belüftung durch das Offnen eines Ventils zur umgebenden Atmosphäre, sodass die Kammer mit dem Umgebungsgas(gemisch) gelüftet wird. Denkbar ist auch eine Überdruckbeaufschlagung der Kammer mit einem Gas bzw. Gasgemisch anstatt einer Belüftung zur umgebenden Atmosphäre.

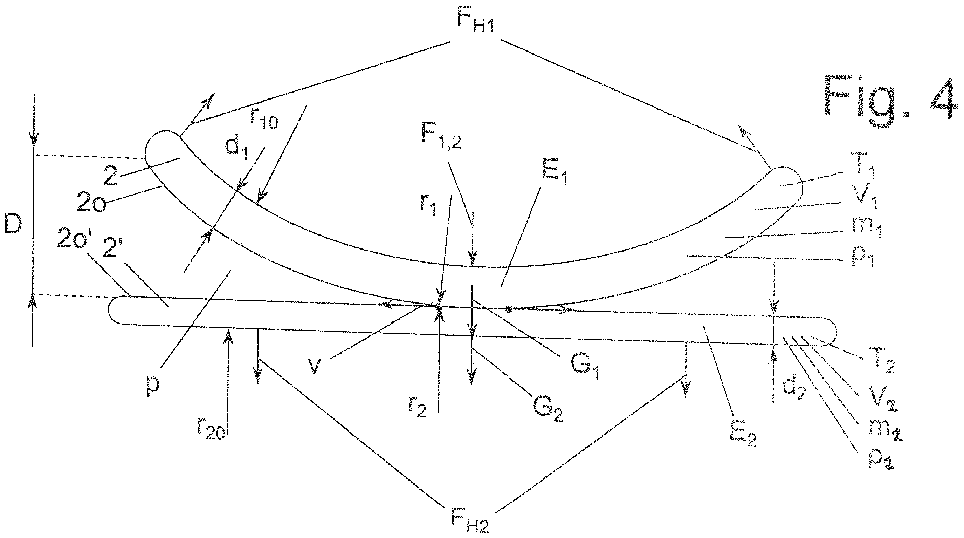

Die Figur 4 zeigt eine schematische, nicht maßstabsgetreue Darstellung zweier Substrate 2, 2', die durch eine Vielzahl von Parametern definiert werden. Die Substratoberflächen 2o, 2o' entsprechen den Biegelinien des ersten oberen Substrats 2 bzw. zweiten, unteren Substrats 2' in einem definierten Zeitpunkt. Sie werden maßgeblich durch die oben genannten Parameter definiert. Ihre Form ändert sich als Funktion der Zeit während des erfindungsgemäßen Bondvorgangs.

### Bezugszeichenliste

- 1, 1': Probenhalter
- 1o, 1o': Probenhalteroberflächen
- 2, 2': Substrate
- 2o, 2o': Substratoberflächen
- 2i: Substratrückseite
- 3, 3': Fixierung
- 4: Bohrung
- 5: Löcher
- 6: Verformungsmittel
- 7: Kontaktpunkt
- 8: Bondwellenfront
- 9: Messmittel
- 10: Substratstapel
- 11: Heizung
- 12: Lichtquelle
- F₁, F₂: Kraft
- F_{H1}, F_{H2}: Haltekraft
- v: Bondwellengeschwindigkeit
- T_{H}: Heiztemperatur
- T1, T2: Substrattemperaturen
- E1, E2: Substrat E-Moduli
- d1, d2: Substratdicken
- V1, V2: Substratvolumina
- m1, m2: Substratmassen
- ρ1, p2: Substratdichten
- G1, G2: Substratgewichtskräfte
- r1, r2: Substratkrümmungsradien
- r10, r20: Ausgangssubstratkrümmungsradien
- D: Substratrandabstand

## Patentansprüche

1. Vorrichtung zum Bonden eines ersten Substrats (2) mit einem zweiten Substrat (2'), aufweisend Messmittel (9) zur Erfassung einer Bondwelle (8), insbesondere einer Bondwellenfront (8),
**dadurch gekennzeichnet,**
**dass** die Bondwelle (8) in Abhängigkeit der Erfassung der Bondwelle (8) steuerbar ist.

2. Vorrichtung nach Anspruch 1, wobei die Messmittel (9) derart ausgebildet sind, dass eine Substratrückseite (2i) des ersten Substrats (2), bevorzugt ein Bondinterface zwischen den Substraten (2, 2'), erfassbar ist.

3. Vorrichtung nach einem der vorhergehenden Ansprüche, wobei die Erfassung eine Vermessung der Bondwelle (8), insbesondere der Bondwellenfront (8), umfasst.

4. Vorrichtung nach einem der vorhergehenden Ansprüche, aufweisend einen ersten Probenhalter (1) zur Halterung des ersten Substrats (2) mit einer Haltekraft F_{H1} und einen zweiten Probenhalter (1') zur Halterung des zweiten Substrats (2') mit einer Haltekraft F_{H2}, wobei mindestens eine der Haltekräfte (F_{H1}, F_{H2}) auf 0 (Null) reduzierbar ist, um die Bondwelle (8) zu steuern.

5. Vorrichtung nach einem der vorhergehenden Ansprüche, wobei ein Zustand der Bondwelle (8), insbesondere der Bondwellenfront (8), erfassbar ist, wobei insbesondere ein Fortschreiten der Bondwelle (8), insbesondere der Bondwellenfront (8), erfassbar ist.

6. Vorrichtung nach einem der vorhergehenden Ansprüche, wobei eine Position der Bondwelle (8), insbesondere ein Bondwellenverlauf, und/oder eine Größe einer gebondeten Fläche erfassbar ist.

7. Vorrichtung nach einem der vorhergehenden Ansprüche, wobei die Messmittel (9) Optiken und/oder Kameras, insbesondere visuelle Kameras und/oder Infrarot-Kameras, umfassen.

8. Vorrichtung nach einem der vorhergehenden Ansprüche, wobei die Messmittel (9) Leitfähigkeitsmessgeräte, insbesondere zur Messung einer Oberflächenleitfähigkeit, insbesondere durch eine Kontaktierung zweier Elektroden an zwei gegenüberliegenden Positionen eines Substrats (2, 2'), insbesondere kontaktieren die Elektroden einen Rand der Substrate (2, 2'), umfassen.

9. Vorrichtung nach einem der vorhergehenden Ansprüche, wobei die Bondwelle (8) durch kontrolliertes und schrittweises Lösen einer Fixierung, insbesondere Vakuumfixierung, eines Probenhalters (1, 1') steuerbar ist, insbesondere durch gezieltes, radialsymmetrisches, insbesondere von innen nach außen durchgeführtes, Lösen vom Probenhalter (1, 1').

10. Vorrichtung nach einem der vorhergehenden Ansprüche, wobei die Erfassung der Bondwelle (8) über einen Zeitraum von mehr als 1s, vorzugsweise mehr als 2s, noch bevorzugter mehr als 3s, am bevorzugtesten mehr als 4s, am allerbevorzugtesten mehr als 5s, erfolgt.

11. Vorrichtung nach einem der vorhergehenden Ansprüche, wobei die Erfassung der Bondwelle (8) über eine, insbesondere radiale, Position der Bondwelle (8) durchführbar ist, insbesondere solange, bis sich die Bondwelle (8) an einer radialen Position befindet, die mindestens 0.1 mal, vorzugsweise mindestens 0.2 mal, noch bevorzugter mindestens 0.3 mal, am bevorzugtesten mindestens 0.4 mal, am allerbevorzugtesten 0.5 mal, dem Durchmesser des Substrats (1, 1') entspricht.

12. Vorrichtung nach einem der vorhergehenden Ansprüche, wobei die Erfassung der Bondwelle (8) über einen prozentuellen Anteil der gebondeten bzw. nicht gebondeten Oberfläche erfolgt, insbesondere solange bis mehr als 1%, vorzugsweise mehr als 4%, noch bevorzugter mehr als 9%, am bevorzugtesten mehr als 16%, am allerbevorzugtesten mehr als 25% der Fläche gebondet sind.

13. Vorrichtung nach einem der vorhergehenden Ansprüche, wobei die Steuerung auf Grund von vorgegebenen, eingestellten oder einstellbaren Werten aus der Erfassung erfolgt.

14. Vorrichtung nach einem der vorhergehenden Ansprüche, wobei die Steuerung durch eine gezielte Aufhebung einer Fixierung durch eine kontinuierliche Aufhebung eines Vakuums erfolgt, insbesondere vom Zentrum zum Rand.

15. Verfahren zum Bonden eines ersten Substrats (2) mit einem zweiten Substrat (2') an Kontaktflächen (2o, 2o') der Substrate (2, 2') mit folgenden Schritten, insbesondere folgendem Ablauf:
- Halterung des ersten Substrats (2) an einer ersten Probenhalteroberfläche (1o) eines ersten Probenhalters (1) mit einer Haltekraft F_{H1} und Halterung des zweiten Substrats (2') an einer zweiten Probenhalteroberfläche (1o') eines zweiten Probenhalters (1') mit einer Haltekraft F_{H2},
- Kontaktierung der Kontaktflächen (2o, 2o') an einer Bondinitiierungsstelle (20) und Heizen zumindest der zweiten Probenhalteroberfläche (1o, 1o') auf eine Heiztemperatur T_{H},
- Bonden des ersten Substrats (2) mit dem zweiten Substrat (2') entlang einer von der Bondinitiierungsstelle (20) zu Seitenrändern (2s, 2s') der Substrate (2, 2') verlaufenden Bondwelle,
**dadurch gekennzeichnet, dass**
das die Heiztemperatur T_{H} an der zweiten Probenhalteroberfläche (1o') während des Bondens reduziert wird.
